(19) Europäisches Patentamt
European Patent Office
Office européen des brevets

(11) **EP 4 432 489 A1**

(12) **EUROPEAN PATENT APPLICATION**
published in accordance with Art. 153(4) EPC

(43) Date of publication:
**18.09.2024 Bulletin 2024/38**

(21) Application number: **22892532.7**

(22) Date of filing: **20.10.2022**

(51) International Patent Classification (IPC):
**H01S 5/11** $^{(2021.01)}$    **H01S 5/34** $^{(2006.01)}$

(52) Cooperative Patent Classification (CPC):
**H01S 5/11; H01S 5/34**

(86) International application number:
**PCT/JP2022/039093**

(87) International publication number:
**WO 2023/085032 (19.05.2023 Gazette 2023/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **11.11.2021 JP 2021184428**

(71) Applicant: **RIKEN**
**Wako-shi, Saitama 351-0198 (JP)**

(72) Inventors:
• **Yun, Joosun**
**Wako-shi Saitama 351-0198 (JP)**
• **LIN, Tsung-Tse**
**Wako-shi Saitama 351-0198 (JP)**
• **HIRAYAMA, Hideki**
**Wako-shi Saitama 351-0198 (JP)**

(74) Representative: **Huebner, Stefan Rolf**
**Postfach 101317**
**80087 München (DE)**

(54) **QUANTUM CASCADE LASER ELEMENT**

(57)    To provide a surface-emitting quantum cascade laser that can easily achieve high power with low divergence operation, the PhC-QCL element 1000 of the present disclosure has a first electrode 101, which is a film extending beyond a certain range, a semiconductor superlattice structure 11 0, and a second electrode 102 disposed on or above the semiconductor superlattice structure. The semiconductor superlattice structure has an active region 112 comprising a plurality of unit structures that are repeatedly stacked. The second electrode has an array of apertures that forms, for example, a triangular lattice. The second electrode has no electrically isolated areas in the range. Preferably, the active region is provided with column holes shaped to match the openings in the second electrode as a similar triangular lattice arrangement.

FIG. 1

EP 4 432 489 A1

**Description**

Technical Field

The present disclosure relates to quantum cascade laser elements. More particularly, the present disclosure relates to the quantum cascade laser elements that emit electromagnetic waves with surface emission.

Background Art

Recently, quantum cascade lasers, hereinafter referred to as QCLs, have attracted attention as solid-state light sources that radiate or emit electromagnetic waves in the mid-infrared and terahertz (THz) ranges. QCL elements have a semiconductor superlattice structure in which the unit structure is formed repeatedly over the thickness direction, and the profile of the conduction band edge potential acting on the electrons inside (hereinafter simply referred to as the potential) generally has multiple wells (wells) and barriers (barriers) in each unit structure. When an external voltage is applied to operate a QCL element, the potential of the wells and barriers of the semiconductor superlattice structure becomes uneven and generally ramps according to its thickness. Electrons, which serve as carriers, are transported through subbands, or levels, formed in a sloped and uneven potential, and undergo inter-subband transitions repeatedly, causing stimulated emission of electromagnetic waves for lasing operation. The name "cascade" is given to the behavior of electrons as they are transported, losing energy as they undergo transitions between subbands. In QCL elements, lasing operation is possible to select a lasing wavelength independently of the energy gap of the semiconductor superlattice structure material. The lasing wavelength can be varied through the design of the semiconductor superlattice structure. Therefore, QCL elements are attracting attention as coherent light sources in the mid-infrared and terahertz (THz) regions, which are wavelength ranges (frequency ranges) where solid-state light sources have not been available in the past.

In general, QCL elements are edge-emitting devices that operate in TM-mode optical transitions and emit their TM-mode electromagnetic waves from, for example, the edge surface of the QCL element. This is because, based on the selection rule required for optical transitions of electrons in semiconductor superlattice structures, electromagnetic waves coupled by inter-subband transitions are limited to those in which the electric field is directed over the thickness direction. For QCL elements with a stacked structure, such electromagnetic waves are in the TM mode, and the output of the TM mode is emitted from the edge surfaces of the QCL element, such as the cleaved surfaces. The process of fabricating practical devices with QCL elements emitting from the edge surface (mounting process) tends to be complicated and is not suitable for integration.

In general, surface emitting semiconductor lasers, which emit light with wavenumber components normal to the plane shape, have various advantages over end-emitting ones, including resistance to facet damage, wavelength stability, simplified packaging, low beam divergence, and scalability at the wafer level. If QCL elements can be operated with surface emission, the above-mentioned complexity of the packaging process can be alleviated, and furthermore, it is expected that QCL elements can be made larger in area and integrated by fabricating semiconductor and metal layers on a substrate. One of the methods to perform surface emission in QCL elements operating in TM mode is to employ photonic crystals (see, for example, Patent Document 1 and Non-Patent Documents 1-3).

Citation List

Patent Document(s)

Patent Document 1: JP 2017-168594 A

Non-Patent Document(s)

Non-Patent Document 1: R. Colombelli, K. Srinivasan, M. Troccoli, O. Painter, C. F. Gmachl, D. M. Tennant, A. M. Sergent, D. L. Sivco, A. Y. Cho, F. Capasso, "Quantum cascade surface-emitting photonic crystal laser," Science 302(5649), 1374-1377 (2003), https://doi.org/10.1126/science.1090561

Non-Patent Document 2: Guozhen Liang, Houkun Liang, Ying Zhang, Lianhe Li, A. Giles Davies, Edmund Linfield, Siu Fung Yu, Hui Chun Liu, and Qi Jie Wang, "Low divergence single-mode surface-emitting concentric-circular-grating terahertz quantum cascade lasers", Optics Express Vol. 21, Issue 26, pp. 31872-31882 (2013), https://doi.org/10.1364/OE.21.031872

Non-Patent Document 3: Y. Chassagneux, R. Colombelli, W. Maineult, S. Barbieri, H. E. Beere, D. A. Ritchie, S. P.

Khanna, E. H. Linfield, and A. G. Davies, "Electrically pumped photonic-crystal terahertz lasers controlled by boundary conditions," Nature 457, 174-178 (2009), https://doi. org/10.1038/nature07636

Summary of Disclosure

Technical Problem

The inventors of this application conceived of a concept for QCL elements employing photonic crystals (referred to as "PhC-QCL elements" in this application) that would enable higher performance and searched for a specific structure. This disclosure contributes to the performance improvement of QCL elements by providing PhC-QCL elements that can be easily made to have high output power and are expected to perform lasing operation with low divergence.

Solution to Problem

The inventors of this application investigated PhC-QCL elements that can operate in surface emission among various PhC-QCL elements. The inventors of the present application have investigated various preferred structures of PhC-QCL elements by making full use of theoretical calculations including the FDTD (time-domain difference method) and FDM (filter diagonalization method), which are well-established calculation methods. As a result, we found that the practicality of the PhC-QCL element can be greatly enhanced by ingenious use of photonic crystals, and we have thus completed the invention of the invention claimed in the present application. When the photonic crystal in the PhC-QCL element is suitable, photons generated by inter-subband transitions in the semiconductor superlattice structure contribute to laser lasing operation in the radiation mode, in which photons are emitted in the normal direction of the plane. In such a case, the electrodes should not have electrically isolated areas in order to provide adequate power to a semiconductor superlattice structure with a typical stacked periodic structure. PhC-QCL elements that employ photonic crystals with such photonic bands will provide high-performance surface emitting QCL elements.

That is, in an embodiment of the present disclosure provided is a quantum cascade laser element comprising: a first electrode, which is a uniform film extending over a range; a semiconductor superlattice structure disposed on or above the first electrode and having an active region consisting of a plurality of unit structures that are stacked repeatedly; and a second electrode disposed on or above the semiconductor superlattice structure, wherein the second electrode has a photonic crystal including an array of apertures that pass through the photonic crystals in a thickness direction, the photonic crystal being formed to extend over the range, the array of apertures configured such that the second electrode has no electrically isolated portions in the range; and wherein the photonic band structure of the photonic crystal has a radiation mode at or near the $\Gamma$ point.

The suitability of a photonic crystal can also be determined by whether the photonic band of the photonic crystal has a radiating mode at or near the $\Gamma$ point at the desired laser frequency. Furthermore, the suitability of the mode at or near the $\Gamma$ point can be determined by the prerequisite that "provided that a parasitic mode, which is another mode with a large horizontal wavenumber ($k_{//}$), exists at the same frequency in that photonic band, the parasitic mode must have a sufficiently larger radiation constant than the radiating mode at or near the $\Gamma$ point". More preferably, the suitability of the mode at or near the $\Gamma$ point can also be determined by whether the radiation mode at or near the $\Gamma$ point has a radiation constant of 10/cm to 40/cm. This is because efficient surface radiation and amplification, i.e., stable, and high-power emission, can be expected in this range of radiation constants.

Therefore, in the above embodiment, it is preferable that the radiation constant of the radiation mode be smaller than the radiation constant of another mode having a larger horizontal wavenumber at the same frequency as the radiation mode. In the above embodiment, it is also preferable that the radiation constant of the radiation mode be within the range of 10/cm and 40/cm, inclusive.

That is, in an embodiment of the present disclosure provided is a quantum cascade laser element, comprising: a first electrode, which is a uniform film extending over a range; a semiconductor superlattice structure disposed on or above the first electrode and having an active region consisting of a plurality of unit structures that are stacked repeatedly; and a second electrode disposed on or above the semiconductor superlattice structure, the second electrode having a triangular lattice array of apertures extending over the range and having no electrically isolated portions in the range, the apertures passing through the photonic crystal in a thickness direction.

That is, in an embodiment of the present disclosure provided is a quantum cascade laser element, comprising: a first electrode, which is a uniform film extending over a range; a semiconductor superlattice structure disposed on or above the first electrode and having an active region consisting of a plurality of unit structures that are stacked repeatedly; and a second electrode disposed on or above the semiconductor superlattice structure, wherein, in the second electrode is formed a photonic crystal including an array of apertures of equilateral triangles, the aperture passing through the photonic crystals in a thickness direction, the photonic crystal being formed to extend over the range, and wherein the second electrode has no electrically isolated portions in the range.

In this application, electromagnetic waves in the THz range refer to electromagnetic waves in the frequency range of approximately 0.1 THz to 30 THz, i.e., in the wavelength range of about 10 $\mu$m to 3 mm. In addition, the description of this application may use technical terms diverted or borrowed from the fields of electronic devices and physics related to visible light and infrared light when describing element structures and functions. For this reason, even in descriptions of electromagnetic waves in the frequency or wavelength range of the THz region, which is far from visible light, the terms "light," "laser," and "emission," and the terms "optical -" (optical -), "light -" (photo -), "refraction" etc., may be used.

Advantageous Effects of Disclosure

The quantum cascade laser element provided in any of the aspects of the present disclosure performs a highly practical surface emitting lasing operation, contributing to the development of quantum cascade lasers and electronic devices that use them.

Brief Description of Drawings

FIG. 1 is an illustration showing the schematic structure of an example PhC-QCL element whose performance is evaluated in an embodiment of the present disclosure.
FIG. 2 is a diagram showing the photonic bands calculated for a PhC-QCL element of an embodiment of the present disclosure.
FIG. 3 is an illustration showing the concept of a two-dimensional reciprocal space in an embodiment of the present disclosure.
FIGS. 4A-C show a three-dimensional perspective of the unit cell (FIG. 4A), a cross-sectional view of the same unit cell cut through the center in y-coordinate (FIG. 4B), and a cross-sectional view of the semiconductor superlattice structure at the center of its thickness (FIG. 4C), for the unit cell considered for the calculation of a PhC-QCL element in an embodiment of the present disclosure.
FIGS. 5A-B show a three-dimensional perspective view of the waveguide structure (FIG. 5A) and a cross-section in the yz plane cutting through the center of the semiconductor superlattice structure (FIG. 5B) for a PhC-QCL element employed for the calculation of a PhC-QCL element in an embodiment of the present disclosure.
FIG. 6A-B are diagrams of the photonic bands calculated for a PhC-QCL element of an embodiment of the present disclosure.
FIG. 7 is a graph of surface loss for modes near the Γ point, calculated using FDM for a PhC-QCL element of an embodiment of the present disclosure.
FIGS. 8A-B are graphs of the real (FIG. 8A) and imaginary (FIG. 8B) parts of $\varepsilon_r$(f) and n(f) calculated for a PhC-QCL element of an embodiment of the present disclosure.
FIGS. 9A-C are maps showing the magnitude of electric field components of $|Ex(x,y)|$, $|E_Y(x,y)|$, and $|Ez(x,y)|$ obtained after performing a running discrete Fourier transform (RDFT) at 2.77 THz on a planar sensor, calculated for a PhC-QCL element in an embodiment of the present disclosure.
FIGS. 10A-F are map diagrams showing the intensity of electric field components as a function of y and z coordinates at the two YZ planar sensor locations calculated for a PhC-QCL element of an embodiment of the present disclosure.
FIG. 11 is a graph showing the fields and their Fourier transforms at a point sensor in a semiconductor superlattice structure calculated for a PhC-QCL element of an embodiment of the present disclosure.
FIG. 12A-B are a far-field pattern (FIG. 12A) and a radiation pattern (FIG. 12B) calculated based on the vector potential method, calculated for PhC-QCL element 1000 of an embodiment of the present disclosure.
FIG. 13 is a diagram of photonic bands in a comparative example of the present disclosure, in a unit cell similar to FIG. 4C, the active layer occupancy ratio is set to 0.571 with a = 64 $\mu$m and a circle radius r = 22 $\mu$m, for a structure with a cylindrical air hole with h = 8.5 $\mu$m.
FIG. 14A-C are a perspective view (FIG. 14A), a plan view (FIG. 14B), and a cross-sectional view at a position through the center of the square (FIG. 14C) of the photonic crystal unit cell to be calculated in a comparative example of the present disclosure.
FIG. 15 is an illustration of the irreducible Brillouin zone in the reciprocal space of a square lattice in a comparative example of the present disclosure.
FIG. 16 is a perspective view of a QCL waveguide structure with unit cells deployed to calculate the performance in the far field in a comparative example of the present disclosure.
FIG. 17A-C are diagrams of the photonic bands calculated for the comparative example of the present disclosure.
FIG. 18 is an illustration of the degrees of freedom provided for optimizing the cross-sectional shape of the column holes in a unit cell in an embodiment of the present disclosure.

FIG. 19 is a plan view of the cross-sectional shapes of various column holes tested in an embodiment of the present disclosure.

FIGS. 20A-B are band diagrams (FIG. 20A) and far-field patterns (FIG. 20B) for a PhC-QCL element structure with optimized column hole cross-sectional shapes in an embodiment of the present disclosure.

FIGS. 21A-B are results of calculations under the conditions studied in detail in an embodiment of the present disclosure, which are modes of photonic bands in configurations with column holes with circular- (FIG. 21A) and equilateral triangular- (FIG. 21B) cross-sections.

FIG. 22A is a graph illustrating calculation results under certain conditions studied in detail in an embodiment of the present disclosure, showing the active layer occupancy ratio - frequency relationship for equilateral triangular-shaped column holes and circular-shaped column holes.

FIG. 22B is a graph illustrating calculation results under certain conditions studied in detail in an embodiment of the present disclosure, showing the active layer occupancy ratio - LEE relationship for equilateral triangular column holes and circular column holes.

FIG. 22C is a graph illustrating calculation results under certain conditions studied in detail in an embodiment of the present disclosure, showing the frequency-LEE relationship for equilateral triangular column holes and circular column holes.

FIG. 23A-B are the electric field distribution (FIG. 23A) and the far-field pattern (FIG. 23B) under certain conditions studied in detail in an embodiment of the present disclosure.

FIG. 24A is a graph showing calculation results under certain conditions studied in detail in an embodiment of the present disclosure, showing the active layer occupancy ratio - frequency relationship for equilateral triangle-shaped column holes and circular column holes.

FIG. 24B is a graph showing calculation results under certain conditions studied in detail in an embodiment of the present disclosure, showing the active layer occupancy ratio - LEE relationship for equilateral triangular column holes and circular column holes.

FIG. 24C is a graph showing calculation results under certain conditions studied in detail in an embodiment of the present disclosure, showing the frequency-LEE relationship for equilateral triangular column holes and circular column holes.

FIGS. 25A-B are beam profiles under one condition (FIG. 25A) and another condition (FIG. 25B) studied in detail in an embodiment of the present disclosure.

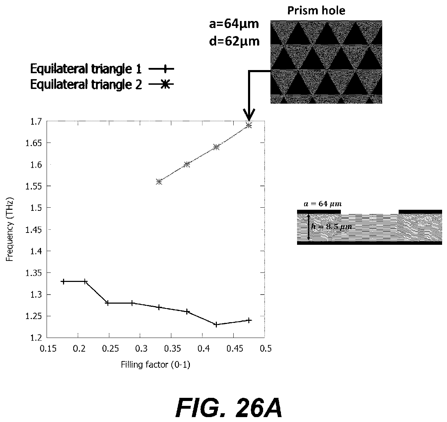

FIG. 26A is a graph illustrating calculation results under one condition studied in detail in an embodiment of the present disclosure, showing the FF-frequency relationship.

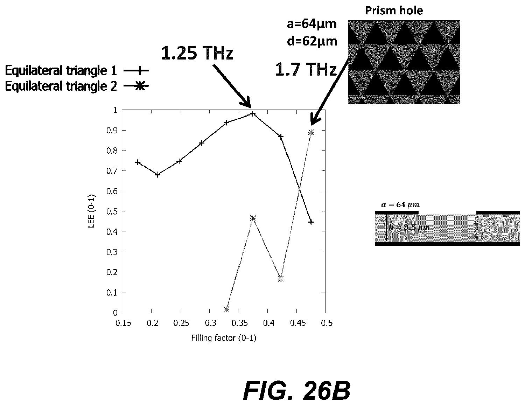

FIG. 26B is a graph illustrating calculation results under certain conditions studied in detail in an embodiment of the present disclosure, showing the FF-LEE relationship.

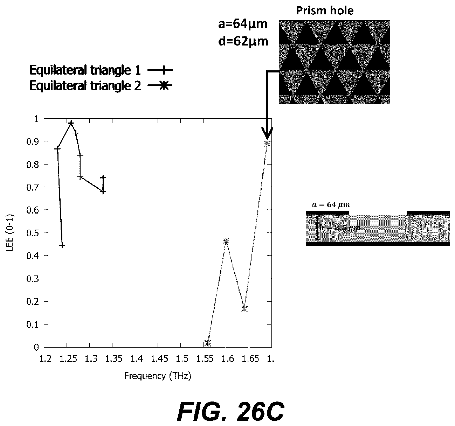

FIG. 26C is a graph illustrating calculation results under certain conditions studied in detail in an embodiment of the present disclosure, showing the frequency-LEE relationship.

FIG. 27A is a graph illustrating calculation results under certain conditions studied in detail in an embodiment of the present disclosure, showing the active layer occupancy ratio - frequency relationship for two modes in an equilateral triangular-shaped column hole.

FIG. 27B is a graph illustrating calculation results under certain conditions studied in detail in an embodiment of the present disclosure, showing the active layer occupancy ratio - LEE relationship for two modes in an equilateral triangular column hole.

FIG. 27C is a graph illustrating the calculation results under certain conditions studied in detail in an embodiment of the present disclosure, showing the frequency-LEE relationship for two modes in an equilateral triangular-shaped column hole.

FIG. 28A-B are photonic band structures (FIG. 28A) and far-field patterns (FIG. 28B) under certain conditions studied in detail in an embodiment of the present disclosure.

Description of Embodiments

The quantum cascade laser elements of the present disclosure are described below. For all drawings, the common reference numerals are given to common part or element unless otherwise noted. ※ In addition, each element in the drawing should be understood as not being drawn to scale.

1. Concept

In the embodiment of the present disclosure, a structure of a QCL element (PhC-QCL element) is provided that employs photonic crystals to enable QCL elements - which normally operate emitting light in the TM mode - to operate in surface emitting mode. The present embodiment of the PhC-QCL element has, in particular, a schematic structure with a first electrode layer/active layer/second electrode layer for surface emission operation in which one electrode layer (second electrode) side is the radiating surface. The first and second electrodes are typically both metal. At least in the second electrode layer, periodic structures that form photonic crystals are fabricated by etching or other means. The active layer is the layer for the semiconductor emission operation and has a semiconductor superlattice structure consisting of multiple unit structures that are stacked repeatedly. Specific designs may have the periodic structure in the semiconductor superlattice structure, in addition to the second electrode, fabricated by etching or other means to become part of the photonic crystal described above. In the embodiment of the present disclosure, two types of embodiments are mainly described as in the following order: an embodiment in which the electrode (second electrode) and the semiconductor superlattice structure, which is the radiating surface of the surface emission, both form a photonic crystal, and an embodiment in which only that electrode (second electrode) forms a photonic crystal.

1.1 Structure

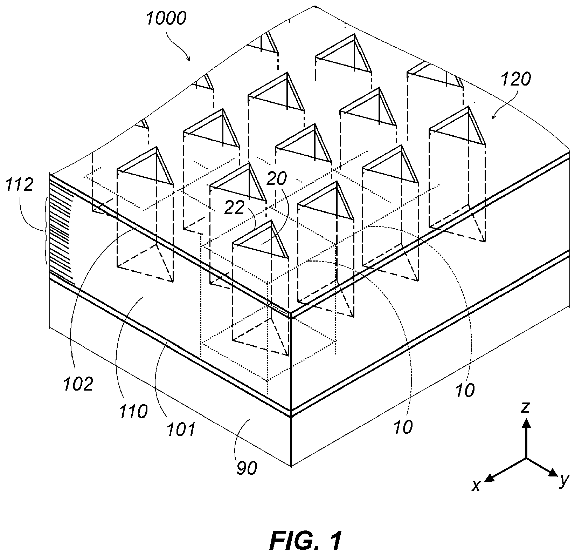

FIG. 1 illustrates the schematic structure of an example PhC-QCL element 1000 whose performance is evaluated in the present embodiment. The PhC-QCL element 1000 is generally composed of a pair of electrodes 101 and 102 and a semiconductor superlattice structure 110 that is sandwiched therebetween. The electrodes (first electrode) 101 and electrode (second electrode) 102 are utilized to receive from an external source voltages to form an electric field and currents to emit or radiate electromagnetic waves to the semiconductor superlattice structure 110. The semiconductor superlattice structure 110 has an active region 112 consisting of a plurality of unit structures that are stacked repeatedly. Additionally, the semiconductor superlattice structure 110 may include other layers necessary for operation.

The electrodes 101 and 102 are typically formed of metal, with the electrode 101 being a uniform film with a certain range. The typical thickness of electrode 101 is determined arbitrarily so that transmission is not of concern for electromagnetic waves of the operating frequency. Electrode 101 may be supported on some substrate 90. The electrode 102 is provided with a pattern of holes (apertures 22) such that no electrically isolated portions are found in the range of the unit cell 10. The typical thickness of electrode 102 is also determined similarly to electrode 101, to a thickness that is not transparent to electromagnetic waves. The half-space above the electrode 102 (in the direction of the z-axis in the figure) is typically filled with a vacuum or air, as there is no medium that has a significant effect on the electromagnetic waves of the frequency of operation. However, it is possible to place a material above electrode 102 whose dielectric constant or refractive index is small as compared to the semiconductor superlattice structure 110, etc. (not shown in the figure). For the electrodes 101 and 102, the physical constants for perfect conductors, for which we do not need to consider transmission in the calculations described below, are employed. Even in the case where a metallic film without sufficient thickness or a transmissive material is employed for the electrodes 101 and 102, calculations and design modifications can be easily made to reflect the material parameters of the real conductor by considering the electromagnetic response of the substrate 90 and the semiconductor superlattice structure 110. The design changes are easy for a person skilled in the art.

The semiconductor superlattice structure 110 has an active region 112. The active region 112 is stacked with a number of (e.g., 100) repeating unit structures. Other layers are formed in the semiconductor superlattice structure 110 for electrical operation, such as a highly doped n-type layer (not shown). Thus, the semiconductor superlattice structure 110 may include layers that are not shown explicitly.

The unit of the periodic structure of the photonic crystal 120 in the PhC-QCL element 1000 is the unit cell 10 shown as a rectangle in FIG. 1. The unit cell 10 includes at least an electrode 101, a semiconductor superlattice structure 110, and an electrode 102, in this order along the thickness direction. In numerical calculations described below, even the vacuum and air portions described above may be included in the unit cell 10. The unit cell 10 typically encompasses at least one column hole 20 and is defined in such a way that the extent of the photonic crystal 120 can be filled with many of the same shape in two dimensions. In other words, the photonic crystal 120 is structured by laying or "tiling" the unit cells 10 down over the xy-plane of FIG. 1, where all the unit cells 10 are provided with the column holes 20. The extent of the unit cell 10 and its shape can be determined arbitrarily as long as they can serve as units of the periodic structure of the photonic crystal 120. The unit cells 10 can also be determined to meet the needs of the various calculations described below. In the present embodiment, the column hole 20 has an aperture 22 in the electrode 102. When a periodic structure is fabricated also in the semiconductor superlattice structure in the present embodiment, the column hole 20 typically has the same cross-sectional shape as the aperture 22 thereof and extends in the direction of the stacking of the unit structure of the semiconductor superlattice structure 110. Such column holes 20 can be fabricated by any technique, such as etching. The electrode 101 is a uniform film over the extent of the photonic crystal 120 that includes the plurality of column holes 20.

In the present embodiment of the photonic crystal 120, the arrangement of the unit cells 10 is such that the column holes 20 are preferably arranged in such a way that the plurality of column holes 20 form a triangular lattice.

The electrodes 102 are electrically conductive across the electrodes 102 spread over many unit cells 10, with the electrodes 102 on either side of at least one of the boundaries separating adjacent unit cells 10 being conductive to each other so that there are no electrically isolated areas within any of the unit cells 10. The specific structure of the photonic crystal 120, i.e., the shape and extent of the unit cells 10 and the specific shape of the column holes 20 in the unit cells 10, is determined in accordance with the final performance. In other words, these specific designs can be adjusted to have good performance at the desired frequency. In this adjustment, there are no specific pre-design requirements for the column holes 20 to be the unit cell 10 and photonic crystal 120 in the present embodiment, for example, the planar shape and depth of the column holes 20 are determined according to the criteria described below for the designed photonic crystal 120. For example, the depth of column hole 20 may be determined so that it passes through both electrode 102 and semiconductor superlattice structure 110, or it may be determined so that it passes only through electrode 102 without entering semiconductor superlattice structure 110 at all. This also applies to the cross-sectional shape of the column hole 20. In order to make a specific design, the photonic bands created by the photonic crystal are carefully studied for suitability.

1.2 Design of Photonic Crystals

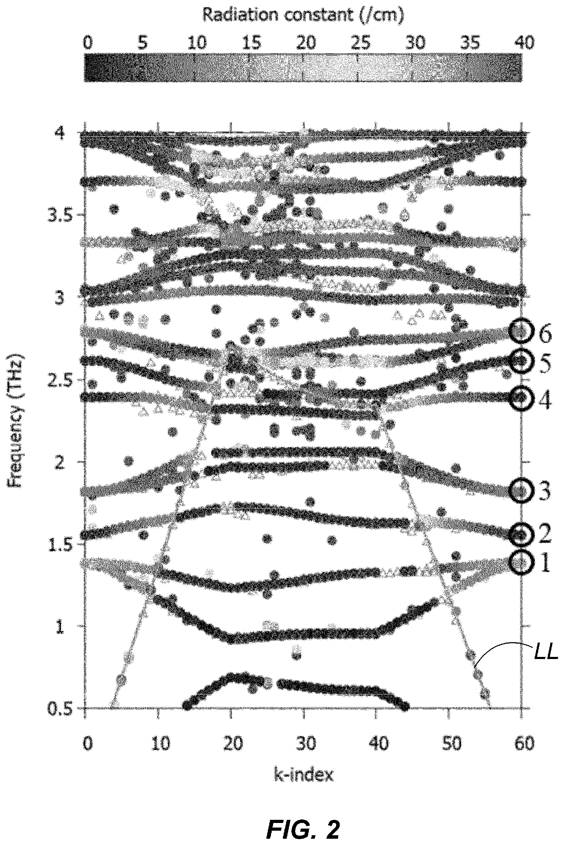

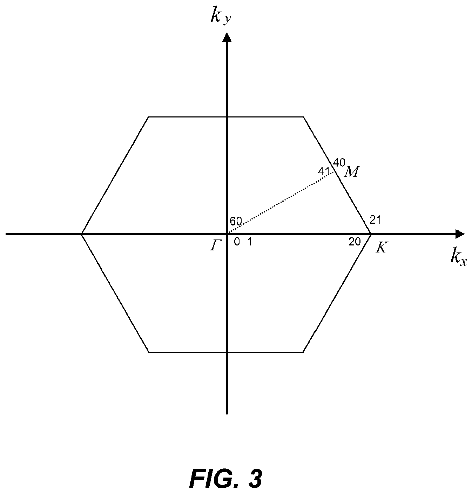

Next, the specific procedure for designing photonic crystals is explained through examples, along with the criteria for judging whether they are favorable or unfavorable. FIG. 2 is a diagram of an example photonic band calculated for the PhC-QCL element of the present embodiment. FIG. 3 illustrates the concept of a two-dimensional reciprocal space of a triangular lattice. The photonic crystal 120 forms photonic bands based on its periodicity. The photonic bands are illustrated in the reciprocal space of the planar extent of the PhC-QCL element 1000 along the XY plane of FIG. 1, i.e., the two-dimensional reciprocal space of the $k_x$ and $k_y$ components of FIG. 3. In FIG. 2, the photonic bands are illustrated by aggregating them into regions enclosed by a small number of feature points, based on the concept of irreducible Brillouin zones based on the symmetry of the photonic crystal, following the customary representation of photonic bands. Specifically, FIG. 2 represents the planar component of the wavenumber vector in the XY-plane reciprocal space of FIG. 1 on the horizontal axis and the vertical axis f as the frequency. The x-indices from 0 to 60 shown on the horizontal axis of FIG. 2 are the planar direction components of the wavenumber vector corresponding to each position on the representative path in FIG. 3, starting from the $\Gamma$ point (k-index 0), passing through the K point (k-index 20) and the M point (k-index 40), and returning to the $\Gamma$ point again, in order of the position in the reciprocal space of FIG. 3. The $\Gamma$, K, and M points are feature points in the triangular lattice. For the sake of illustration, FIG. 2 assumes an infinitely wide and defect-free photonic crystal. The $\Gamma$ point, which corresponds to the left and right ends of the graph in FIG. 2, is the position where the $k_x$ and $k_y$ components of the total wave number vector with three-dimensional components of a real electromagnetic wave are both zero, so that only the remaining $k_z$ component has a non-zero value. In other words, the $\Gamma$ point corresponds to an electromagnetic wave traveling in the direction normal to the plane (FIG. 1, z-axis) for a generally flat (slab) element with a planar extent of 1000 PhC-QCL elements, and the vicinity of the $\Gamma$ point corresponds to a direction slightly inclined from the plane normal direction, with at least one of the $k_x$ or $k_y$ components having a non-zero value. The position where either of the $k_x$ or $k_y$ component is nonzero corresponds to an electromagnetic wave traveling in a direction inclined from the plane normal.

The PhC-QCL element 1000 consists of a PhC slab whose schematic structure is a stacked metal/photonic crystal (PhC)/metal. As shown in FIG. 2, a light line LL can be assumed for the PhC-QCL element. This light line LL defines the boundary between propagation and radiation. In other words, the light line LL defines the boundary such that the mode below it (on the low-frequency side) is the mode that travels inside the flat PhC-QCL element 1000, i.e., the guided mode, which cannot escape from the surface of the slab, whereas the mode above the light line LL (on the high-frequency side) is the mode that can allow electromagnetic waves to be transmitted to the outside, i.e., the radiation mode.

The procedure for designing the photonic crystal 120 in the PhC-QCL element 1000 in the present embodiment is as follows. First, after specifying the shape and size of each part that determines the photonic crystal 120, the photonic band for the photonic crystal 120, which is fabricated including the second electrode 102, is calculated. According to the photonic bands, it is possible to determine which frequencies are suitable, i.e., promising, for lasing operation and external radiation. Namely, if the calculated photonic band has a frequency that achieves the desired radiation profile and the value of the radiation constant required for lasing operation, then the photonic crystal 120 with the photonic band can be characterized as suitably designed at that frequency. If the radiation mode of the photonic band needs further improvement, the shape, extent, and size of the parameters of the photonic crystal 120 are readjusted, and the suitability of the photonic band for lasing operation and external radiation at that frequency is reconsidered based on the above-mentioned criteria. Such readjustments and refinements are repeated so that the required values of the radiation constants and the desired radiation profiles are achieved. The semiconductor superlattice structure 110 of the PhC-QCL element 1000 is then designed for lasing operation for the promising frequencies.

As a preliminary knowledge of the design of the photonic crystal 120, a frequency range is determined such that the semiconductor superlattice structure 110 can lasing in, for example, a normal double-metal-wall waveguide structure, and the frequency range where lasing operation can be performed in the PhC-QCL element 1000 is also reflected in advance. This is because it is useless if the photonic crystal 120 is well designed at a frequency at which the semiconductor superlattice structure 110 cannot be expected to perform lasing. The design of the photonic crystal 120 is then adjusted to search for a suitable frequency for lasing operation of the semiconductor superlattice structure 110. The internal structure of the unit structure of the active region 112 can be used to adjust the performance of the photonic crystal 120. Even if design changes that do not affect the quantum level structure are applied to the semiconductor superlattice structure 110, the lasing frequency range that the semiconductor superlattice structure 110 has is not affected. Therefore, design modifications that do not affect the quantum level structure, such as adjusting the thickness of the active region 112 by changing the number of repeats of the unit structure or adjusting the thickness of additional layers, are useful for adjusting the performance of the photonic crystal 120.

The frequency at which the photonic crystal 120 will have photonic bands suitable for lasing can be modified by adjusting the size to reflect geometric features. This nature allows for adjustment of the suitable frequency for the photonic crystal 120 when the lasing frequency and its range are specified in light of applications. Having determined that the specified lasing frequency is operable for the semiconductor superlattice structure 110, and once the photonic crystal 120 that is advantageous at a frequency close to, if not identical to, the specified lasing frequency has been determined, It is also possible to fabricate a PhC-QCL element 1000 that conforms to the desired lasing frequency and the application fields by adjusting the size of each part of the photonic crystal 120.

1.3 Examples of Photonic Crystal Evaluation

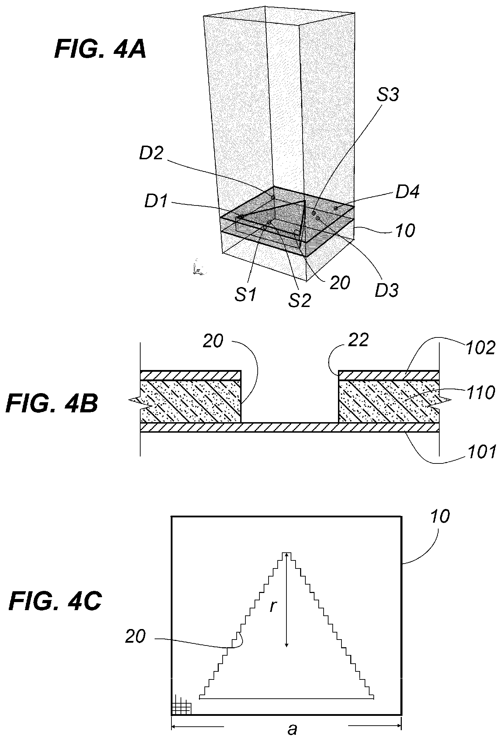

At the candidate lasing frequency, a mode must be found near the Γ point such that the radiation constant is favorable when a photon (electromagnetic wave) of TM polarization is generated in the semiconductor superlattice structure 110. At that frequency, other modes that have large horizontal wavenumbers and cannot be considered near the Γ point, even if they exist, will lose in the mode competition due to their larger radiation constants than the modes near the Γ point. FIG. 2 shows the photonic bands calculated for an equilateral triangular PhC ((a = 64 μm, r = 30 μm, active area occupancy = 0.67, see FIG. 4C) using the calculation methods (DFT and FDM) described below. Based on this calculation example, the selection guideline for lasing frequency candidates will be explained, followed by a more generalized selection guideline. In FIG. 2, the six frequencies are indicated by a circle with the symbols 1-6 at the Γ point, where the k-index is 60. In the explanation regarding this FIG, frequencies 1, etc. refer to these frequencies.

In the present embodiment, once the geometry of the photonic crystal 120 is determined in detail and the photonic bands are calculated, candidate frequencies are first selected such that they have modes near the Γ point. At each candidate frequency, the radiation constants and parasitic modes are mainly investigated. Examples of evaluations for each candidate frequency for the photonic bands in FIG. 2 are as follows:

(Frequency 1) Frequency 1 meets the criteria as a candidate frequency in terms of radiation constant, but there are still concerns due to parasitic modes. This is because if a parasitic mode is created on the light line LL at frequency 1, the parasitic mode may cause unpredictable results. This concern can be removed by estimating with reasonable boundary conditions. Another concern is the presence of multiple modes near the Γ point of the candidate frequency. Thus, the beam quality may be lower than that of pure Γ-point emission.
(Frequency 2) The emission constant of frequency 2 is too small. Therefore, frequency 2 does not meet the criteria as a candidate frequency.
(Frequency 3) Frequency 3 meets the criteria as a candidate frequency in terms of radiation constant, but concerns remain due to parasitic modes. At frequency 3, a parasitic mode is seen on the light line LL, which may cause unpredictable results. Note that the number of modes near the Γ point is smaller at frequency 3 than at frequency 1, and therefore, if no problematic modes are observed on the light line LL, a better beam quality than at frequency 1 is expected to be obtained.
(Frequency 4) Frequency 4 has too small a radiation constant for the modes near the Γ point. Therefore, frequency 4 does not meet the criteria as a candidate frequency.
(Frequency 5) Frequency 5 has too small a radiation constant for the mode near the Γ point. Therefore, frequency 5 does not satisfy the criteria as a candidate frequency.
(Frequency 6) Frequency 6 meets the criteria as a candidate frequency in terms of the radiation constant. This frequency 6 has no parasitic mode in the light line LL. The only possible problem is the interaction between the Γ point mode and the boundary condition.

Based on such evaluations, frequencies 1, 3, and 6 may be promising candidates among frequencies 1-6 in terms of radiation constants and parasitic modes. Specifically, frequencies 1 and 3 are promising, although they require further investigation of parasitic modes. Frequency 6 does not require investigation of parasitic modes and is particularly promising.

The judgment of the suitability of the photonic crystal photonic crystal design in the present embodiment can be explained in a more generalized manner of the specific judgment example described above for the photonic bands in FIG. 2. In general, a photonic crystal is desirable as a design if it satisfies the following requirements at a certain frequency:

C1. the photonic band shall have a radiation mode of the relevant frequency at or near the Γ point (referred to as "target radiation mode" in this section); and

C2. the target radiation mode shall have a radiation constant in a predetermined range (e.g., 10/cm to 40/cm). This is expected to provide efficient surface radiation and amplification.

C3. there is no other mode with a larger horizontal wavenumber ($k_{//}$) at the frequency of the radiation mode in question, or if there is, the target radiation mode shall have a smaller radiation constant relative to that other mode. An example of this other mode is the parasitic mode of the light line.

The radiation constant referred to in the above judgment is the radiation output loss per unit distance, which is derived by determining the complex frequency component using the FDM method and calculating it for each mode. That is, the radiation constant is indicative of the loss of the mode of propagation of the electromagnetic wave, and is a quantity proportional to the reciprocal of the Q-value of resonance. Modes with smaller radiation constants have stronger resonance and narrower spectral widths than modes with larger ones.

For example, suppose that a target radiation mode and a parasitic mode coexist at or near a certain frequency. If the parasitic mode exhibits a smaller radiation constant in comparison with the radiation constant of the target radiation mode, the electromagnetic wave due to induced emission is consumed by the electromagnetic wave amplification of that parasitic mode. Therefore, that frequency is not suitable as a lasing frequency, and the mode at or near the Γ point of that frequency is also not suitable as a target radiation mode. This means that even if the multiple modes that optically couple with each other in lasing operation include a mode at or near the Γ point (target radiation mode) that can be extracted externally, a parasitic mode of the same frequency with a smaller radiation constant (i.e., a higher Q value of resonance) will outcompete in mode competition. Conversely, the target radiation mode will lose out in mode contention if a parasitic mode at a close frequency and the parasitic mode exhibits a smaller radiation constant. As a result, the target radiation mode is relatively less likely to be excited. Note that it is irrelevant whether the parasitic mode having a small radiation constant and can become an obstacle is a waveguide mode or not. Parasitic modes that are waveguide modes do not emit to the outside and become an obstacle. In addition, even if a parasitic mode is not a waveguide mode but contains $k_z$, it is a difficult beam to use if the total wavenumber vector allows the surface emitting beam to have a tilted angle.

On the contrary, if no parasitic mode exists at the desired frequency and only the radiating mode at or near the Γ point is allowed to exist, that frequency is preferable because there is no influence of the parasitic mode, and in addition, if the radiating mode is $k_x = k_y = 0$, emission in the plane normal direction is guaranteed and is even preferable. Even if other parasitic modes coexist with the mode at or near the Γ point, if the mode at or near the Γ point has a relatively smaller emission constant than the parasitic mode, and if the mode at or near the Γ point can beat the mode at or near the Γ point in the mode competition, then the frequency is favorable because it guarantees the emission in the plane normal direction.

From the above, the preferred scenario to achieve emission in the direction normal to the surface with small beam lasing divergence is "that the mode at or near the Γ point (radiation mode) at the desired lasing operation frequency shall have a relatively smaller radiation constant, even if other modes are present" (C3 above).

The mode of the desired frequency in the photonic band can be preferred if it gives either the lower or upper limit of the band gap at or near the Γ point. C above is satisfied because the mode has no modes other than at or near the Γ point.

2. Methodology for Design

In the present embodiment of the disclosure, several methods are combined to investigate example structures for surface emitting photonic crystal quantum cascade lasers. The investigation may include modeling for numerical and theoretical estimation.

In modelling, for reasons of convenience, such as in terms of computational resources and computational speed, the details of the specific structures shown in FIG. 1 may be omitted as appropriate to the extent that they do not affect the results. For example, the stacked structure of the first electrode 101, semiconductor superlattice structure 110, and second electrode 102 is simplified to a structure of a perfect conductor (PEC)/semiconductor layer/PEC, and so on. This replacement is made to describe the first electrode 101 and the second electrode 102 as lossless perfect conductors.

Thereafter, a unit cell analysis is performed. In the unit cell analysis, the photonic band structure and radiation constants are calculated using several variables under periodic boundary conditions. Among the variables here are an active layer occupancy ratio, photonic crystal geometry, frequency, and horizontal wavenumber. The calculation method for unit cell analysis is a combination of the time domain difference (FDTD) method, the Discrete Fourier Transform (DFT) method, and the Filter Diagonalization Method (FDM). As a first step, candidate Γ-point modes for efficient surface radiation are extracted through unit cell analysis.

After completing the unit cell analysis, the far field, field distribution, and light extraction efficiency are analyzed for the frequencies containing the candidate mode. This candidate mode would exist only in the vicinity of the Γ point and would be such that it has a sufficient radiation constant.

Based on the method employed in the present embodiment, the band structure, radiation constants, and far-field calculation method will be described in Section 2.1. The results derived based on unit cells and finite chip area are explained in Section 2.2.

2.1 Calculation of Photonic Bands

2.1.1 Unit Cell Analysis

The FDTD method is used in the present embodiment to calculate the periodic structure of multilayer PhC slabs. FIG. 4A shows a three-dimensional perspective view of the unit cell considered in the present embodiment. In FIG. 4A, spheres S1-S3 and D1-D4, represented in the unit cell 10, are point sensors and dipole radiation sources, respectively. FIG. 4B shows a typical unit cell in a section cut through the center thereof, with column hole 20 extending from aperture 22 through semiconductor superlattice structure 110 in the direction of stacking. The column hole 20 consists of air and a Convolutional Perfect Matched Layer (CPML) in the region where the aperture 22 is not shown in FIG. 4B. FIG. 4C shows a cross-section of the unit cell 10 at the center of the thickness of the semiconductor superlattice structure 110. Here, the mesh of elements set up in the discretized Maxwell's equations is explicitly shown in the lower left corner, thereby clearly showing the microscopic irregularities that occur in the model that reproduces some of the sides of the column hole 20. Although GaAs-based compound semiconductors may be used as a typical material for the semiconductor superlattice structure 110 in this disclosure, the semiconductor superlattice structure 110 is not limited to that material. The boundaries of the +z and -z coordinate axes of the simulation domain were set as CPML. All other boundaries were set to periodic boundaries. To describe the triangular lattice in the simulation domain, a coincident skewed shift was employed for its periodic boundaries. Several dipole radiation sources of TM modes were set at random positions in the semiconductor superlattice structure 110, since the inter-subband transitions dominantly emit TM polarized electromagnetic waves. In the present embodiment, the semiconductor superlattice structure 110 is described as a thick GaAs layer with an average refractive index $n = 12$ according to a typical QCL layer structure, though the present embodiment can be applied to PhC-QCL elements with other materials. The realistic average refractive index $n$ of a QCL structure, even a THz-QCL with a stacked GaAs/AlGaAs layer structure, will vary with changes in barrier thickness, doping density, operating frequency, and optical gain due to the complexity of the quantum cascade structure. Therefore, a better approach for more accurate waveguide design would be to use experimentally measured refractive indices $n$ before starting the design of the unit cell. For the calculation of surface loss, the metal layer is replaced by a lossless perfect electrical conductor (PEC).

The calculation results in the present embodiment give good predictions in the parameter range where replacing the material of electrodes 101 and 102 with PEC does not cause substantial problems. The performance in the wavelength range above 16 μm, i.e., in the frequency range below 18.7 THz, where loss considerations may be unnecessary when real metallic materials are formed under appropriate conditions and shapes, is adequately predicted by the calculation results in the present embodiment.

The discrete Fourier transform (DFT) of the time-marching signal allows the resonant modes of complex waveguide structures to be extracted as a function of frequency and the horizontal wave vector components that form the photonic band structure. Point sensors are placed at random locations in the active region to collect the intensity of the electromagnetic field components as a function of time. The waveform of the dipole emission source of the TM polarization is a cosine-modulated Gaussian in order to generate a broadband at once. After the time evolution, DFT is performed. Before the DFT, a portion of the time signal, including the Gaussian pulse generation, is truncated and discarded. To compensate for the shortcomings of spectral analysis with DFT, FDM analysis is performed simultaneously on the time signal collected by the point sensor. With DFT in FDTD, simulations can take an unreasonably long time when extracting radiation constants and splitting nearby modes together near a certain frequency. In contrast, in FDM, it is difficult to extract modes with very high or too low Q values. The inventors will use both methods simultaneously to investigate a unit cell, thereby reducing the disadvantages of each analysis method.

2.1.2 Spectral Analysis by FDM

The calculation of the radiation constants (quality factors) of the modes generated in the waveguide of the 1000 PhC-QCL element is performed by a time-based spectral analysis of the field using the filter diagonalization method (FDM). In the FDM, the time-evolved field data is fitted to the following equation:
[Math 1]

$$S_{x,y,or\ z}(t) = \sum_{N=0}^{M} a_N e^{-i(2\pi f_N t - \theta_N) - d_N t} \qquad (1)$$

where $a_N$, $f_N$, $\theta_N$, and $d_N$ are the amplitude of the sinusoidal wave, mode frequency, sinusoidal phase difference, and decay constant for the exponential function, respectively, and S is the time-evolving electric or magnetic field component, as calculated by the FDTD method based on Yee's algorithm. Furthermore, N and M are the mode index and the total number of modes extracted by the FDM analysis at a fixed horizontal wavenumber, respectively. The attenuation constant d can be converted to a radiation constant by the equation loss = $2d_N n/c$. The n and c are the refractive index of the QCL material of the semiconductor superlattice structure 110 and the speed of light in vacuum. The quality factor (Q factor) can be converted by $Q_N = \pi f_N / d_N$, but the term "radiation constant" is used in this application instead of Q factor. The radiation constant is defined as the ratio of radiated power loss per unit length of a mode and is equivalent to the surface radiation loss. To fit time-based field data to Equation (1) by FDM, the Harminv 1.4.1 package can be used, for example.

2.1.3 Beam divergence and far field

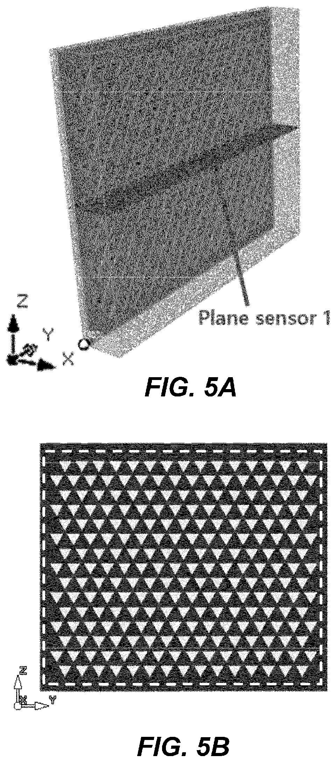

The beam pattern, divergence angle, and emitted/absorbed power in surface emission operation in the PhC-QCL device 1000 can be estimated using the near field to far field conversion (NF-FF conversion) and the Pointing's theorem. To observe these, 15 (16) x 15 unit cells with specific boundary conditions and limited chip area were arranged. In this configuration, 15 columns and a half (for 7 unit cells) in the x direction and 15 rows in the y direction were placed as shown in Figures 5a and 5b. To express that an additional 7 unit cells are added due to the symmetry at both ends of the x direction, we describe 15 (16) x 15 unit cells, in this disclosure. To observe the field distribution of the PhC-QCL, two planar sensors, several point sensors, and a box sensor are installed for observing the field distribution, light output, and beam pattern. FIG. 5A is a 3-D perspective view of the waveguide structure employed for the calculation of the 1000 PhC-QCL elements. For convenience of calculation, the xyz axis is taken in a different way and the thickness direction is taken in the x-axis. FIG. 5B shows a cross-sectional view of the semiconductor superlattice structure 110 in the yz plane cutting through the center of the structure. The edge boundaries along the ±x-axis of the box sensor are located near the CPML on the ±x-axis. The placement of this box sensor is indicated by the white dotted line. For the purposes of this calculation, all boundaries are set on the CPML. In a realistic case, efficient absorbers would have to be attached to the +y, -y, +z, and -z boundaries in Figure 5a to suppress reflections by the boundaries, which could result in higher order modes. We used CPML to represent the realistic and efficient absorbers in order to reduce the substantial computational resources required. Note that if the absorber boundary does not exist, higher-order modes are likely to occur, which may interfere with the intended behavior. Here, the realistically efficient absorber is represented by CPML, which greatly reduces the required computational resources.

To describe laser amplification, the Lorentz model was employed assuming that the active region 112 of the semiconductor superlattice structure 110 is a linear gain material. In order to accurately and realistically describe laser operation within the semiconductor superlattice structure 110, the three-dimensional Maxwell-Bloch equations must be modeled and solved to account for the detailed epitaxial structure and doping profiles in the unit structure of the active region 112. However, since our goal is to estimate the beam divergence of the waveguide structure for the PhC-QCL device 1000 employing a suitable photonic band, the Lorenz model assuming linear gain material is sufficient. The Lorenz model is expressed by the following equation (2).
[Math 2]

$$\varepsilon_r(f) = \varepsilon_{r,base} + \frac{\varepsilon_{LORENTZ} \cdot \omega_o^2}{\omega_o^2 - 2i\delta_o 2\pi \cdot f - (2\pi \cdot f)^2} \qquad (2)$$

where $\varepsilon_r$, $\varepsilon_{r,base}$, $\varepsilon_{LORENTZ}$, $\omega_o$, and $\delta_o$ are the total dielectric constant, base material dielectric constant, Lorentz dielectric constant, Lorentz resonance, and Lorentz line width, respectively. In order to describe the geometrical factors in a reasonable and consistent manner, the same simulation parameters used for the unit cell calculations are applied to the large area PhC-QCL waveguide calculations, except for the dimensions of the total planar area of the waveguide structure and $\Delta t$. To initiate the chip-level calculations, a dipole radiation source with TM polarization and a point sensor are placed at random locations on the semiconductor superlattice structure 110, which is simulated in GaAs. Two planar sensors are placed on the semiconductor superlattice structure 110, on the right PEC, and near the CPML at the +x boundary, respectively. All sensors collect field intensity as a function of time for later processing purposes. After the time evolution processing is completed, NF-FF transform, DFT, and optical power calculation are performed.

3. Example 1 (Configuration employing an equilateral triangular lattice)

The present embodiment will be explained by specific calculation results, with the preferred configuration found as an example and the configuration to be contrasted as a comparative example.

3.1 Analysis of the unit cell structure satisfying the concept of FIG. 1

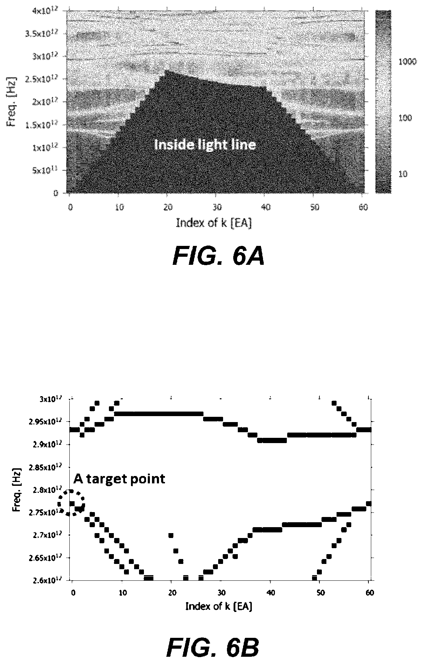

In the unit cell structures of FIGS. 4A through 4C based on the conception of FIG. 1, the photonic bands were extracted by performing numerical calculations applying h = 8.5 $\mu$m, r = 28 $\mu$m, and a = 64 $\mu$m. FIG. 6 is a diagram of the photonic bands extracted. The spatial discretization of the simulation domain was fixed at $\Delta x$ = 1.28 $\mu$m, $\Delta y \sim$ 1.11 $\mu$m, and $\Delta z$ = 0.5 $\mu$m. For the calculation of photonic bands, a unit time step was fixed as $\Delta t \sim$ 2.86 x $10^{-16}$ s. The discretized Maxwell's equations based on Yee's methodology were solved in 3 x $10^5$ iterations with that $\Delta t$. Since the purpose of the investigation is to extract modes that satisfy the concept of FIG. 2 when TM polarized photons are generated in the semiconductor superlattice structure 110, the TM polarized dipole radiation sources were placed only within the QCL region of the semiconductor superlattice structure 110. FIG. 6A shows the relative field intensities after Fourier transform as a function of k index, which represents the frequency and the irreducible Brillouin zone. Here, k indices of 0, 20, 40, and 60 correspond to Γ, K, M, and Γ points, respectively (FIG. 3). The frequency with field strength stronger than the intensity in the very near vicinity means that a resonance mode or modes exist at that frequency for a fixed wavenumber vector. We omitted the region below the light line because we are not interested in resonant modes below the light line. In general, when the light lines are indicated in the band diagram, the frequency region below the light lines is sometimes indicated with black out. A complete band gap was observed near the region between 2.8 and 2.9 THz. FIG. 6B is a diagram of the photonic bands extracted by post-processing a magnified view of the vicinity of the band gap frequency range. FIG. 6B clearly shows the frequencies having resonance modes only at the Γ point just below the band gap.

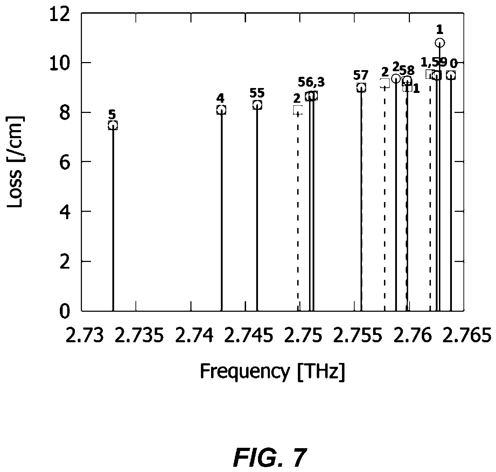

FIG. 7 is a graph of surface loss for modes near the Γ point, calculated using FDM for the PhC-QCL element. FDM analysis was performed over the 0 $\leq$ $k_{index}$ $\leq$ 5 and 55 $\leq$ $k_{index}$ $\leq$ 59 regions in FIGS. 6A and 6B. The unit cell structure was recalculated after employing a narrow bandwidth modulated Gaussian waveform to reduce the error rate in the FDM analysis. The time marching iterations of the narrow bandwidth waveform were performed 1.5 x $10^6$ times. A center frequency of $f_c$ = 2.775 THz and a bandwidth of 0.1 THz were applied to the waveform to generate a narrow bandwidth near the desired Γ point. The time constant of the narrow bandwidth modulated Gaussian waveform was determined by 8.58/$\pi$/(bandwidth). The mode located at 2.7638 THz on the rightmost side of FIG. 5 is the mode of the Γ point extracted by FDM. The square and circle marks in FIG. 5 refer to positive and negative frequencies, respectively, and each number attached to the apex indicates the k index in FIG. 4. The wave number vectors $k_x$ and $k_y$ for the mode with k index 1 near k index 0 are 2834 $m^{-1}$ and 0 $m^{-1}$, respectively. Since the surface loss in that case is greater than the surface loss in the mode at the Γ point, one would expect that beam divergence could increase for the mode near the Γ point as the coupling between the modes becomes stronger. Such beam divergence can also be suppressed by designing the semiconductor superlattice structure 110 so that the energy giving the maximum gain is slightly above the Γ-point mode. The search for a better unit cell structure, i.e., a precise optimization of the unit cell geometry to have a better surface loss map than in Fig. 7 for PhC-QCLs, is also possible (described below as Example 2).

3.2 Far-field and Field of View Distribution

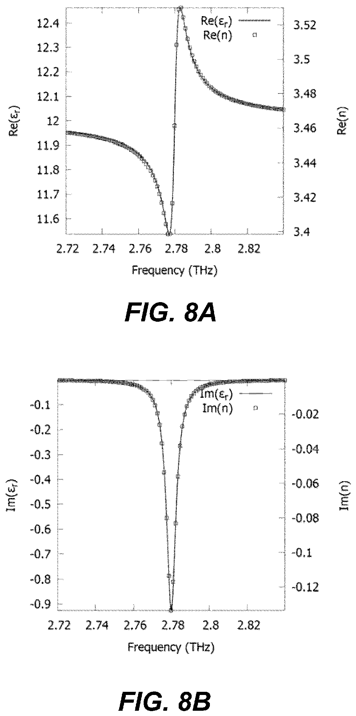

In the design described in 2.1, the far-field pattern and field-of-view distribution were calculated for a structure constructed by uniformly arranging 15 (16) x 15 unit cells. In that calculation, $\Delta t \sim$ 1.289 x $10^{-15}$s was employed, and the time marching iteration of solving Maxwell's equations was repeated 2 x $10^5$ times. The overall geometric structure is identical to that in FIGS. 5a and 5b. Point, box, and plane sensors are set up to collect the time-dependent field intensities and perform post-processing. After amplified modes in the active region 112, or gain medium, in the semiconductor superlattice structure 110 become dominant, all Fourier transforms are performed following 60,000 iterations for spectral analysis of the electromagnetic waves inside and outside the PhC-QCL element 1000. The Lorentz model parameters for the gain medium are given as $\varepsilon_{r,base}$ = 12, $\varepsilon_{LORENTZ}$ = -0.002, $\omega_o$ = 2.780 THz and $\delta_o$ = 3 GHz. FIGS. 8A and 8B show the real (FIG. 8A) and imaginary (FIG. 8B) parts of $\varepsilon_r(f)$ and n(f) calculated by the Lorenz model and the parameters described above.

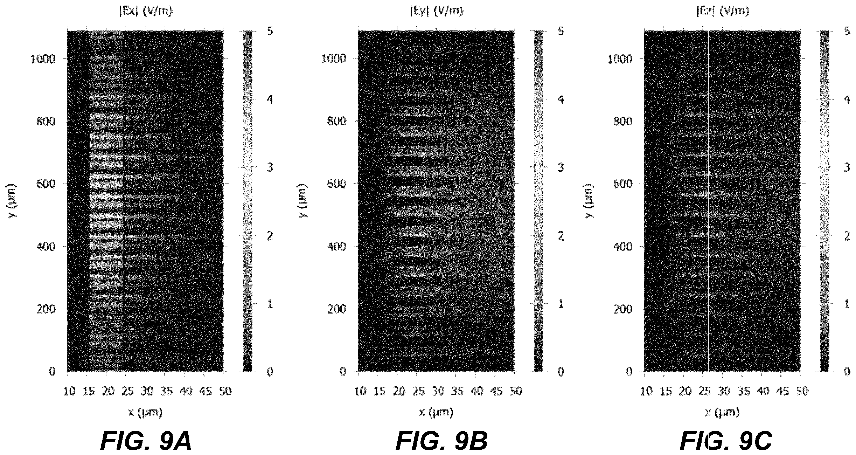

FIGS. 9A-C are maps showing the magnitude of the field components of |Ex(x,y)|, |E$_Y$(x,y)|, and |Ez(x,y)| after performing a running discrete Fourier transform (RDFT) at 2.77 THz on a flat sensor. The field distribution results seem to be overwhelmingly dominated by radiation in the direction normal to the plane relative to inclined directions. The field distribution at the end of the time marching was also very similar to the distribution in FIG. 9. Since the CPML was set as the boundary, the field distribution near the edge gradually diminishes and the periodic field pattern is no longer observed near the boundary. FIGS. 9A-C show the same results as expected from the unit cell calculations, even for a countably small number of unit cells, 15 (16) x 15 unit areas (EAs).

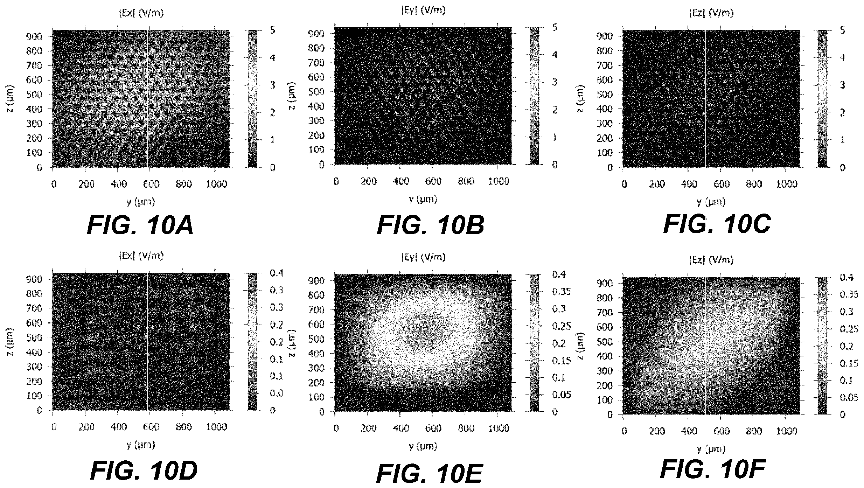

FIGS. 10A-F illustrate the intensity of the electric field components as a function of the y and z coordinates at the two YZ-plane sensor locations. The first YZ-plane sensor is located at the middle thickness of the semiconductor superlattice structure 110. The second YZ-plane sensor is located at a distance of 100 $\mu$m between the PhC-QCL element 1000 and that sensor, i.e., 100 $\mu$m away from the PhC-QCL element 1000 in the x direction in FIG. 5A. FIGS. 10A-C and FIGS. 10D-F are the distributions of |Ex(y,z)| |E$_Y$(y,z)| or |Ez(y,z)| at the first and second planar sensors, respectively. The results in FIGS. 10A-F additionally illustrate that the energy is concentrated to some extent near the center of the entire waveguide, similar to that shown in FIGS. 9A-C. The field distributions in the two planar sensors show that beam divergence can be reduced by increasing the number of unit cells and by increasing the planar area. The asymmetry of the field pattern comes from imperfections due to discretization in describing each triangular column hole and the asymmetric positioning of the triangular column holes throughout the 1000 PhC-QCL element.

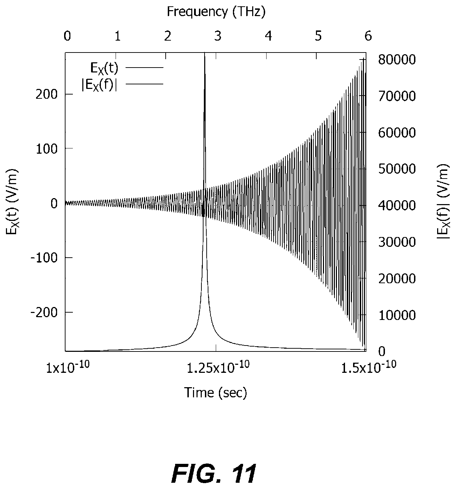

FIG. 11 shows the field and its Fourier transform in a point sensor in a semiconductor superlattice structure 110. The swinging curve recorded by this point sensor clearly shows exponential amplification. The Fourier transform of the curve shows sharp peaks. An FDM analysis was also performed based on the field data in FIG. 11. The peak frequency and loss of Ex(f) in FIG. 11 were derived by FDM to be 2.77357 THz and -20.27 cm$^{-1}$, respectively. The calculated loss of the semiconductor superlattice structure 110 at 2.77357 THz based on the Lorentz model in FIG. 8B was about -27.867 cm$^{-1}$. Negative losses correspond to positive gains. Thus, the sum of the surface and interface losses is about 7.597 cm$^{-1}$ The discrepancy between 7.597 cm$^{-1}$ and FIG. 7 comes from whether the Lorentz model is applied or not.

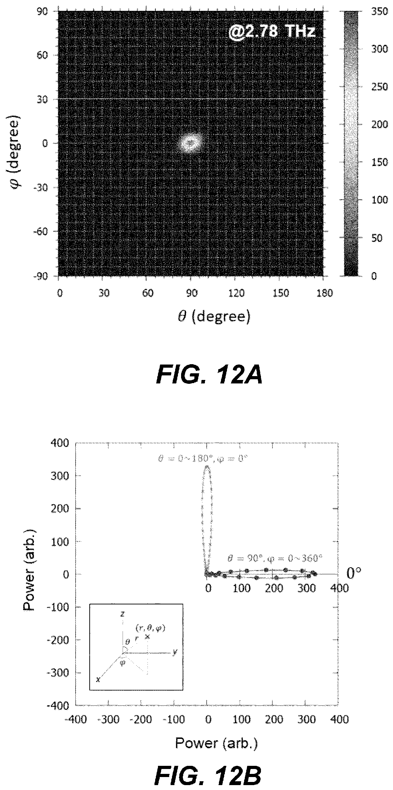

FIG. 12A is the far-field pattern calculated for the 1000 PhC-QCL element, based on the vector potential method, and FIG. 12B is its radiation pattern. For the NF-FF conversion, an additional YZ planar sensor was set up that fills the inside of the chain line in FIG. 5B. The distance in x-coordinate between that planar sensor and the 1000 PhC-QCL element is 110 $\mu$m near the CPML boundary. FIG. 12A provides a heat map presentation of the far-field as a function of $\theta$ and $\varphi$ for the spherical coordinates illustrated in the inset of FIG. 12B. The distance of observation point r from QCL was fixed at 1000 m. FIG. 12B depicts the radiation pattern when $\theta$ = 90° or $\varphi$ = 0°. Typical beam divergence is calculated based on the full width at half maximum (FWHM) of the far-field pattern. The beam divergences at the two cut lines of $\theta$ = 90° and $\varphi$ = 0° were about 3.7° and 4.7°, respectively. The maximum intensity in the far field was centered to the normal direction to the plane. Beam divergence is reduced as the chip area and the number of unit cells increase.

For the purpose of increasing the external quantum efficiency (EQE), it is necessary to also minimize the optical power that travels in the in-plane direction through the slab of the semiconductor superlattice structure 110 of the PhC-QCL element 1000 toward the boundary and is absorbed at the interface. The ratio of the radiated power through the surface versus the power absorbed through the interface of the slab of semiconductor superlattice structure 110 (referred to in this disclosure as the "power ratio") is 1.958:1 for FIG. 9.

4. Example 2 (Optimization performed on Example 1)

We further performed detailed optimization of the above-mentioned configuration. Specifically, in the unit cell structure shown in FIG. 4A-C, where a = 64 $\mu$m, h = 8.5 $\mu$m, and r = 28 $\mu$m and the lasing frequency was set to 2.775 THz, we have maintained a = 64 $\mu$m and changed to h = 6 $\mu$m and r = 32 $\mu$m. The lasing frequency is accordingly set to 2.76 THz. As a result, although the structure of the photonic bands shows little difference in figure from that of FIG. 6B, good performance is achieved at the $\Gamma$ point or in the slightly tilted direction (near the k index 58 in FIG. 6B). In the optimized version, the power ratio between the radiated power through the surface versus the power absorbed through the interface of the slab of semiconductor superlattice structure 110 is 20.6:1. We believe that the reason for this is that by changing the size of each section in the photonic crystal shown in FIG. 4A-C to h = 6 $\mu$m and r = 32 $\mu$m, the reflectivity of electromagnetic waves propagating in-plane through the photonic crystal increased and the amount of electromagnetic waves reaching the interface of the slab decreased.

5. Comparative Example 1 (Triangular Lattice with Circular Air Holes)

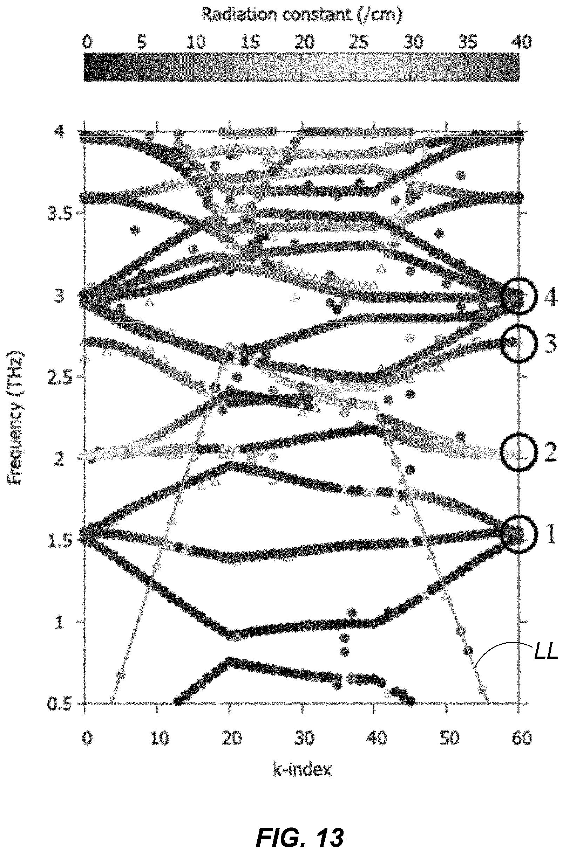

The surface emission PhC-QCL waveguide established in this disclosure is compared with another structure (Comparative Example 1) that has cylindrical air holes in the metal layer and active region. The unit cell structure of Comparative Example 1 has a cylindrical air hole. FIG. 13 is a photonic band diagram for the structure of Comparative Example 1 with cylindrical air holes, where a = 64 $\mu$m, the active layer occupancy ratio is 0.571 with a circle radius r = 22 $\mu$m, and h = 8.5 $\mu$m in a unit cell similar to FIG. 4C. As in FIG. 2 above, the candidate frequencies are indicated by circles. In the same manner as in FIG. 2, the suitability for each candidate frequency of the photonic band in the case with cylindrical air holes in FIG. 13 can be determined as follows.

a. Frequency 1 has too small a radiation constant for the mode near the $\Gamma$ point. Thus, it cannot meet the established criteria.
b. Frequency 2 is 2.02 THz, which could satisfy the criteria in terms of radiation constant as a candidate frequency, but parasitic modes on the light line at the target frequency could cause unpredictable results. Therefore, an estimation with reasonable boundary conditions is required. Another concern is that there are a number of modes near the $\Gamma$ point of this candidate frequency2. Modes that are not pure $\Gamma$-point emission may degrade the beam quality. Furthermore, modes below the light line detected by DFT (Discrete Fourier Transform) will also become a significant problem, hampering high LEE.
c. Frequency 3 denotes a mode in which the radiation constant near the $\Gamma$ point is too low.
d. Frequency 4 denotes a mode in which the radiation constant near the $\Gamma$ point is too low.

As such, the photonic bands obtained by photonic crystals with cylindrical air holes are unfavorable for lasing operation in comparison with those with equilateral triangular air holes.

6. Comparative Example 2 (Square Lattice with Right Angle Isosceles Triangular Air Holes)

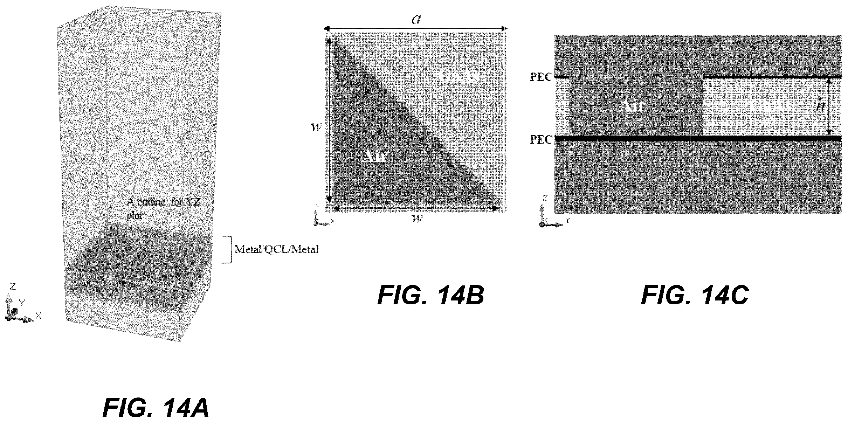

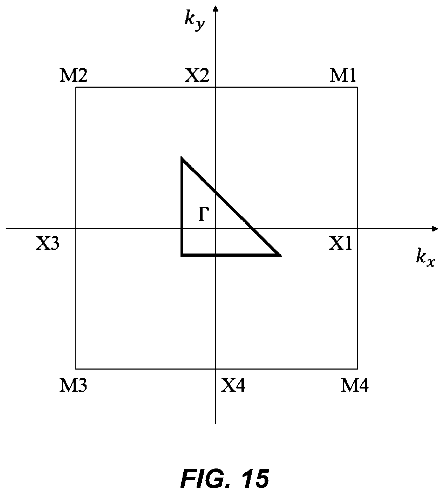

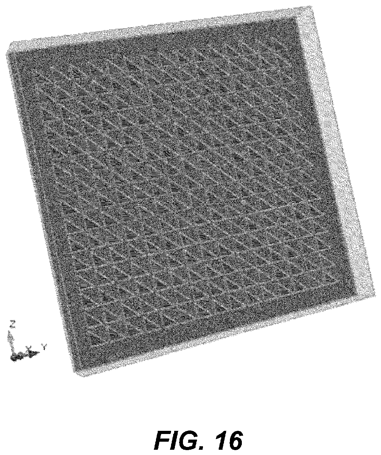

As Comparative Example 2, the structure of a square lattice photonic crystal with a column hole whose cross-sectional shape is a right-angled isosceles triangle, as disclosed in Patent Document 1, FIG. 9 (third embodiment), was investigated according to the method in the present disclosure. FIGS. 14A-C are a perspective view (FIG. 14A), a plan view (FIG. 14B), and a cross-sectional view at a position through the center of the square (FIG. 14C) of the unit cell of the photonic crystal to be calculated in Comparative Example 2. FIG. 15 illustrates the irreducible Brillouin zone in reciprocal space of a square lattice. FIG. 16 is a perspective view of a comparative Example 2 QCL waveguide structure in which a unit cell is arranged to calculate its performance in the far field.
In Comparative Example 2, calculations were exhaustively performed to accurately evaluate the potential of a structure in which the photonic crystal had a square lattice and the cross-sectional shape of the column holes in the unit cell was a right-angled isosceles triangle. That is, a was fixed at 60 $\mu$m, w was varied from 10, 20, 30, 40, 50, 55, and 58 $\mu$m, and h was varied from 6, 8, 10, and 12 $\mu$m for each combination of a and w. Then the following two candidates were selected. The units are both in $\mu$m.

Candidate 1 (a, w, h) = (60, 50, 10)
Candidate 2 (a, w, h) = (60, 55, 6)

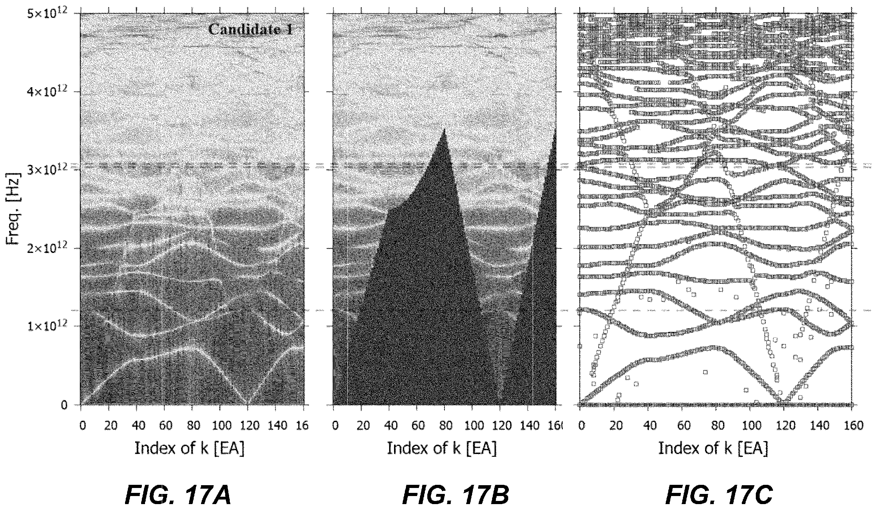

FIGS. 17a-c illustrate the photonic bands calculated in Comparative Example 2, where those for the conditions of Candidate 1 are indicated. The frequencies evaluated were 1.21, 3.02, or 3.07 THz for Candidate 1 and 1.43, 1.54, 2.04, 3.11, or 3.22 THz for Candidate 2. For both candidates, $\varepsilon_{r,base}$ was set to 12 and $\varepsilon_{LORENTZ}$ to -0.002. In the arrangement shown in FIG. 16 for far-field analysis, the number of cells was 15 x 15 EA and CMPL was 2 EA for a total of 17 x 17 EA.
According to FIG. 17A-C, in the photonic crystal with a square lattice of column holes whose cross-sectional shape is a right-angled isosceles triangle, the photonic band structure becomes complicated, and the frequencies where the mode forms only at or near the $\Gamma$ point intersect the light line (FIG. 17A, B). Therefore, in Comparative Example 2, a photonic crystal that satisfies the concept of the present disclosure could not be configured.
In addition, the far field was evaluated using the NF-FF transform. The beam divergence of Candidate 1 was 9.1° and 8.8° (HWHM) for $\theta$ = 90° and $\varphi$ = 0°, respectively, while that of Candidate 2 could not be evaluated due to radiation in two directions. Also, Candidate 1 had a power ratio of 4.45, while Candidate 2 had a power ratio of 13.2. Thus, the structure of Comparative Example 2 not only did not satisfy the concept of the present disclosure, but also could not achieve both small beam divergence and high power ratio.

7. Example 3

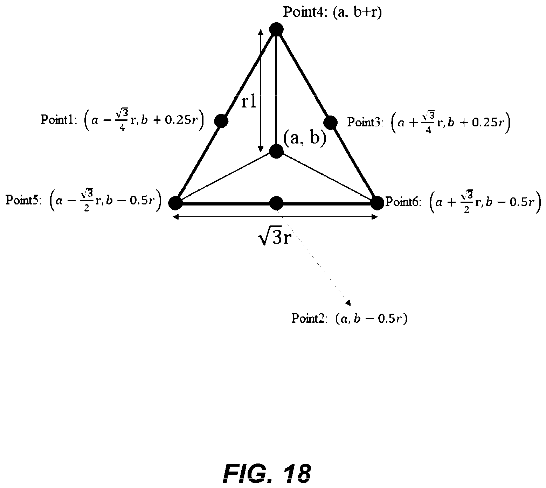

As Example 3 for the embodiment of the present disclosure, we show an example of optimization by extending the cross-sectional shape of the column holes in the unit cell to other than triangular, while maintaining the triangular lattice arrangement. In the optimization, various cross-sectional shapes that are three-fold symmetrical are subjected to trials in response to the fact that the equilateral triangle cross-sectional shape gave good results in Examples 1 and 2. This is because, if the column holes, which are the lattice points, have a cross-sectional shape without three-fold symmetry in a triangular lattice with three-fold symmetry, the mode structure of the photonic bands will become complicated, which departs from the concept of the present disclosure. FIG. 18 illustrates the degrees of freedom given to optimize the cross-sectional shape of the column holes in the unit cell in Example 2. Consider a triangle, "Array Equilateral Triangle", centered at coordinates (a, b) that are representative in the unit cell, which is arranged in a triangular lattice. As shown in FIG. 18, the size of the Array Equilateral Triangle can be specified by the distance r1 from the coordinates (a, b). Assume seven reference points, the midpoints of the three sides forming the equilateral triangle (Point1-Point3) and each vertex of the equilateral triangle (Point4-Point6) at the upper, lower left, and lower right sides of the paper from the center, as well as at the center. The coordinates of each of the seven reference points are shown in FIG. 18. The cross-sectional shape can be expressed by placing small objects (sub-patterns) centered at each reference point and overlapping them with each other as necessary. These subpatterns may or may not be placed, and their size and shape may be changed. The shape of the subpatterns are equilateral triangles, regular hexagons, or disks in the optimization of Example 2. In addition to the distance r1 described above, the length that determines the size of each subpattern can be used to change the cross-sectional shape of the column holes in the unit cell in an extremely diverse manner. In this disclosure, the shape specified by the overlapping range of subpatterns is called the combined shape. In addition to the cross-sectional shape, the depth h of the column hole is also employed as a parameter for the calculation. Considering the process in fabrication of real QCL elements, the case in which the same depth is applied to the sub-patterns to be established at all reference points is taken into account for the calculation. For the sub-patterns, a shape that shows at least three-fold symmetry is also adopted.

For each photonic crystal employing each of these parameter sets, the photonic bands were calculated, the loss was further calculated, and the far field was calculated using the NE-FF transform. The total iteration of time steps for the far field was set to 200,000. In the FFT of the NF-FF transform, the iterations prior to 100,000 of them were discarded.

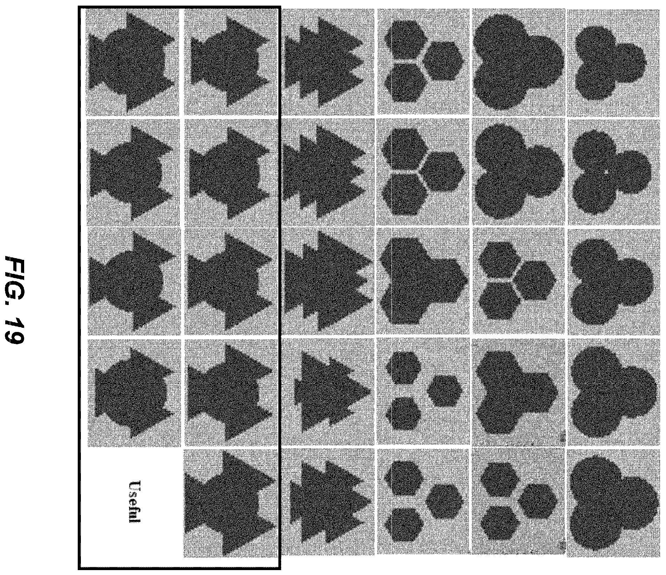

FIG. 19 is a plan view of the cross-sectional shapes of various column holes tried in Example 3 of the present embodiment. The cross-sectional shapes are diverse, employing disks, regular hexagons, and regular triangles for the subpatterns. Actual calculations show that favorable properties were obtained for nine of these cross-sectional shapes, surrounded by solid lines. All of them are combinations of a subpattern disk and three equilateral triangles. The equilateral triangles are identical to one another in size and orientation. In addition, the three equilateral triangles of the combination shape of the favorable properties are arranged so that they are centered in 120° different directions at equal distances with respect to the center of the disk that serves as the subpattern, and the sizes of the three equilateral triangles are such that at least one side of each equilateral triangle does not overlap with the circumference of the disk in its entirety. The cross-sectional shape shown in the first row and second column in FIG. 19 is undesirable because a tiny piece of electrically isolated electrode remains in the center of the three circles.

These are sub-patterns of equilateral triangles with the same orientation such that the centers are at each vertex of the Array Equilateral Triangles. The subpatterns also include disks that have their centers aligned at the centers of the Array Equilateral Triangles. No subpattern is placed at the midpoint of the Array Equilateral Triangle. In this case, in addition to the distance R1 that gives the size of the Array Equilateral Triangle, the parameters are the radius Rc of the disk to indicate the size of the disk, the distance R2 that gives the size of the equilateral triangle of the sub-pattern in the same way as the Array Equilateral Triangle, and the depth h of the column hole.

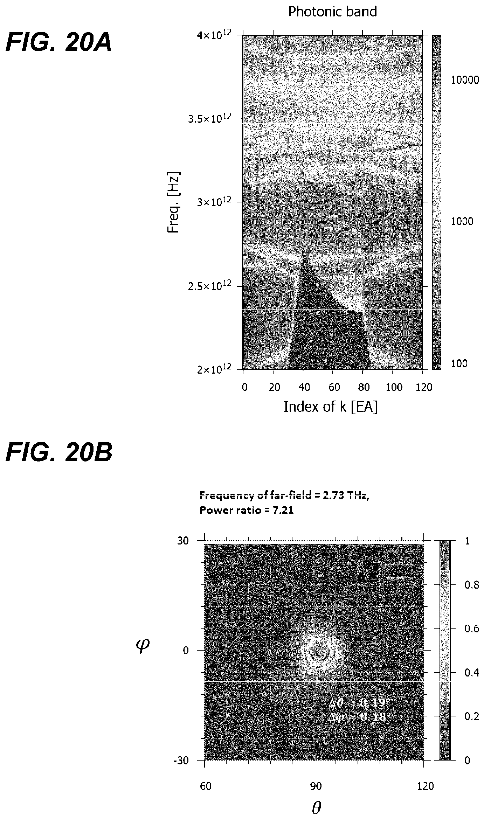

Table 1 lists the calculation parameters used for the area enclosed in FIG. 19, the operating conditions, and the performance estimated by numerical calculations. FIG. 20A is a band diagram with Rc = 18, R1 = 30, R2 = 21, and h = 6.0, and FIG. 20B is the far-field pattern with that structure.

[Table 1]

| (Rc,R1,R2,h) [$\mu$m] | FREQUENCY [THz] | POWER RATIO | ($\Delta\theta$, $\Delta\phi$) [DEGREE] | BEAM PROFILE |
|---|---|---|---|---|
| (18, 28, 17, 8.5) | 2.750 | 0.539 | (9.8, 13.9) | POOR |
| (18, 30, 17, 8.5) | 2.746 | 0.965 | (11.4, 11.4) | POOR |
| (18, 30, 19, 6.0) | 2.700 | 7.08 | (9.36, 9.21) | POOR |
| (18, 30, 19, 8.5) | 2.780 | 3.32 | (9.50, 6.87) | ELLIPTIC |
| (18, 30, 21, 6.0) | 2.730 | 7.21 | (8.19, 8.18) | NEARLY GAUSSIAN BEAM |

(continued)

| (Rc,R1,R2,h) [μm] | FREQUENCY [THz] | POWER RATIO | ($\Delta\theta$, $\Delta\phi$) [DEGREE] | BEAM PROFILE |
|---|---|---|---|---|
| (18, 32, 17, 8.5) | 2.758 | 1.09 | (10.23, 7.16) | ELLIPTIC |

As shown in Table 1, it is possible to design a QCL element that exhibits an extremely good far-field pattern with a power ratio between 1.958:1 in Example 1 and 20.6:1 in Example 2, by adopting a cross-sectional shape that overlaps three squares and a disk.

8. Detailed Study With Limited Symmetry

Based on the knowledge of symmetry confirmed by the above-mentioned investigations including Example 1 and Comparison Example 2, a more detailed study was conducted focusing on light extraction efficiency (LEE). This included study of patterns (8.1) and investigation of the difference between electrode-only openings or column holes (8.2), particularly in the case of the useful three-fold symmetry.

8.1 Study on Patterns

The conditions under which high light extraction efficiency (LEE) is possible for the circular and equilateral triangular patterns were clarified. The conditions shown in FIG. 4A through FIG. 4C were adopted, and the following assumptions were added:

~ The absorption by the structure is assumed to be zero.
~ The fraction of the component passing through the plane cutting the x-axis at the position where the x-coordinate is large among the two planes perpendicular to the x-axis out of the radiation output traveling in all directions, i.e.,

$$P_{+x}/(P_{+x}+P_{-x}+P_{+y}+P_{-y}+P_{+z}+P_{-z})$$

is denoted as LEE. Here, a box sensor is set up as shown in FIG. 5A, which surrounds the area where the pattern is provided in FIG. 5B and is cut by two parallel pairs of planes perpendicular to each of the XYZ axes. Let $P_{+x}$ be the radiation output (power) passing through the plane cutting the X axis at the location with the larger X coordinate among the two planes perpendicular to the X axis of that sensor. $P_{-x}$ be the plane cutting the X axis at the location parallel to it and with the smaller X coordinate; the same applies for Y and Z. The two planes perpendicular to the X axis of the box shape in FIG. 5A do not include the CPML (convolutional perfect matching layer) but are located near it; the Y and Z axes are also set to cover the area of the 1000 PhC-QCL element. The above box sensor is located near the CPML in the simulation domain and contains the perfect electric conductor (PEC), the semiconductor superlattice structure 110, and air. Therefore, of the six components in the denominator of the above equation, only $P_{+x}$ is output from the PhC-QCL element 1000 to the space on the side of the second electrode 102 and contributes to radiation, while remaining five components are absorbed or otherwise do not contribute to radiation in the real PhC-QCL element 1000.

In addition, the radiation constant is calculated. The radiation constant is determined by determining the complex frequency component for each component of the electromagnetic wave using the FDM method, and then determining the radiation output loss per unit distance for each mode.

Here, the selection of promising candidates for pattern study followed the following selection policy.

~ The frequencies with modes only in the vicinity of the Γ point were selected as candidates. The predicted photonic band structures corresponding to the candidate frequencies are collected once.
~ The mode at the target frequency should have a radiation constant of 10/cm or better in the THz region.
~ After a sufficient number of unit cells are placed, the beam quality and LEE are estimated by calculating the far-field pattern and near-field optical output.
~ The structure and frequency should then be selected such that the beam quality is high (i.e., vertical radiation with a Gaussian single-lobe geometry where possible) and the LEE is high.
~ The active layer occupancy ratio (=1-FF, where FF is the fill factor of the cross-sectional pattern of apertures or column holes) should be small, which is not desirable. The reason for this is that a small active layer occupancy ratio results in a more complex electron band structure, which reduces the area of photon generation and makes it difficult for current to diffuse in the metal layer of the second electrode 102.

The following more specific criteria were established according to this selection policy

    a. The radiation constant shall be between 10/cm and 40/cm.
    b. No mode exists at the target frequency except in the very vicinity of the Γ point.
    c. However, FDTD, FT (Fourier transform), and FDM sometimes make it difficult to detect modes on the light line. Also Fourier transform or FDM may fail to extract possible modes. Therefore, after placing some unit cells, it is important to estimate the beam quality and LEE by far-field analysis to find the target frequency and mode in FDTD.

Based on the above policy, we adopted the column holes to be placed in each unit cell in a triangular lattice arrangement in the form of cylinders and equilateral triangles, and actually changed the parameters to search for possible candidate conditions. The unit cell of a triangular lattice is specified in the plane as a rectangular area with $(3)^{1/2}/2a$ and a as vertical and horizontal sides. Here, a is a parameter that gives the lattice constant of the triangular lattice and is fixed in the calculation. On cylindrical shapes, the diameter of the circle is changed, and on equilateral triangles, r (FIG. 4C) is changed. In this way, the size of the column hole is changed for both circles and equilateral triangles, where h is the thickness of the semiconductor superlattice structure 110.

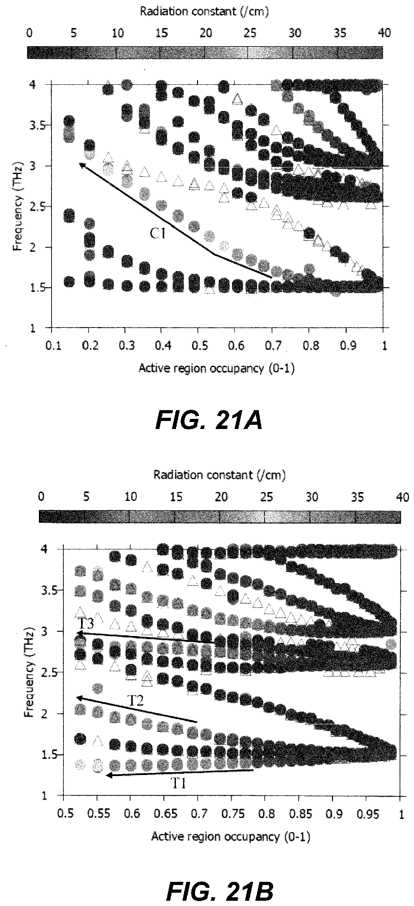

FIGS. 21A and 21B illustrate the photonic band modes in configurations having column holes with circular and equilateral triangle cross-sections, respectively, through the second electrode 102 and the semiconductor superlattice structure 110, calculated as described above when h is set to 85 $\mu$m and a is set to 64 $\mu$m. The horizontal axis is the active layer occupancy ratio (=1-FF), which is close to 1 when the column hole is small. The lower limit of the active layer occupancy ratio is determined by a numerical range such that the second electrode 102 has no electrically isolated areas. The empty triangle represents the frequency of the field intensity peak when the slope of the field intensity, dI/df, switches from positive to negative in the frequency domain after DFT. Here, I denotes the sum of the electrical and magnetic component intensities after DFT from all distributed point sensors. The filled circle symbols in FIG. 3 represent the modes extracted by the FDM analysis. For each electric field component, the modes extracted by FDM are filled in order from the one with the largest error to the one with the smallest error, and the PBS with the radiation constant is observed. Of the modes extracted by FDM, only those with an error rate of less than $10^{-4}$ are considered meaningful. The color of the filled circle means the value of the radiative constant. The scale in FIG. 21A is the same for all figures that illustrate the radiation constants in the present embodiment. From the results plotted based on both DFT and FDM, it is possible to trace the frequency transition trend for each mode as a function of the active layer occupancy ratio. The three modes with active layer occupancy ratios near $\approx$ 1 are located at frequencies near 1.5 THz, 2.5 THz, and 3 THz, respectively. These modes are distributed as a function of active layer occupancy ratio. During the trail of each mode, several irregular modes that deviate from it are observed. Such modes can be caused by numerical noise, incomplete shape definitions due to the coarse discretization of space by Yee's algorithm, and some peculiar scattering phenomena. In the present embodiment, we focus on modes that can be systematically traced as a function of active layer occupancy ratio. In this design, we focus on modes with radiation constants between 10/cm and 40/cm, since the goal is to achieve stable, high-power luminescence. If the planar shape of the circular or equilateral triangle is smaller than a certain dimension, no electrically isolated area is generated in the second electrode 102, but if it is larger than that dimension, the circular or equilateral triangle reaches the boundary of the unit cell and overlaps those of the adjacent unit cell, causing an electrically isolated area in the second electrode 102. Therefore, the lower limit of the active layer occupancy ratio, which reflects the upper limit of the dimension where no electrically isolated area is generated, is also determined geometrically and is, in the case of circular or equilateral triangles, about 0.093 and exactly 0.5, respectively. The conditions employed in the numerical calculations are such that the lower limit above is slightly larger than the geometric value, in accordance with the requirement of having no electrically isolated areas. When the radiation constants were calculated, those that met the criteria were the modes that varied along the lines of C1 in FIG. 21A for circular column holes and along the lines of T1, T2, and T3 in FIG. 21B for equilateral triangular column holes. FIGS. 21A and B indicate that for the circular (C1) and uniform triangular (T1-T3) columnar photonic crystals, one and three modes with radiation constants of 10/cm or higher were found, respectively. Such modes are indicated by black arrows in FIG. 21A and B as a function of active layer occupancy ratio. Although some of the 3 THz-derived trajectories in FIGS. 21A and B meet the established simple selection criteria, the frequencies of the Γ point modes derived from 3 THz have a complex band structure as a function of horizontal wavenumber, which means that severe mode competition arises. Therefore, we will not analyze such modes.

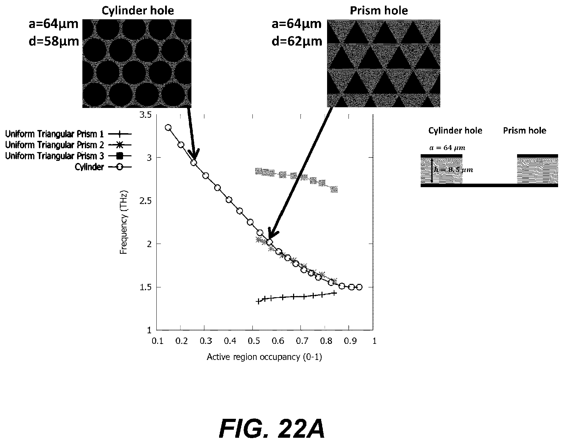

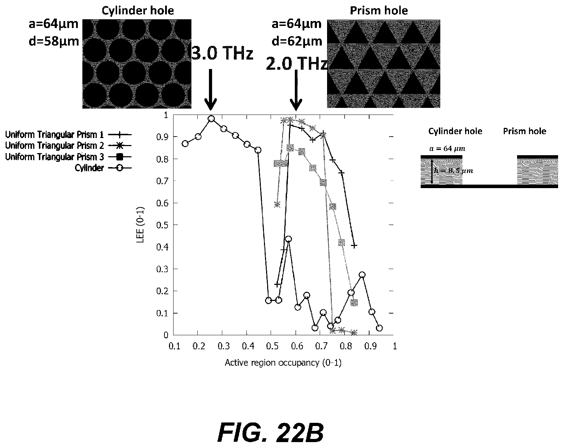

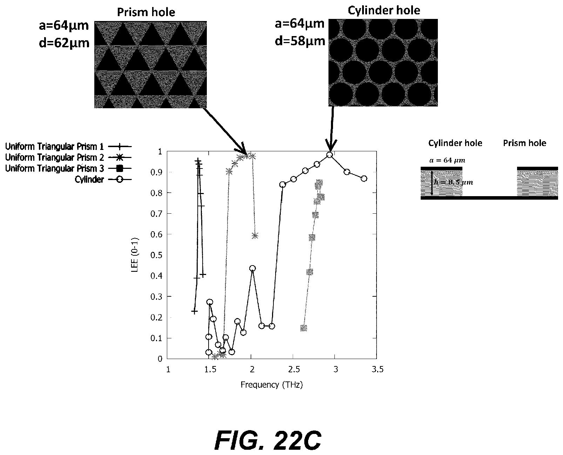

FIGS. 22A-C are graphs showing the variation in performance when the active layer occupancy ratio is varied along the lines C1 and T1-T3 (FIG. 21A, B) by altering the shape parameters, the active layer occupancy ratio - frequency (FIG. 22A), active layer occupancy ratio -LEE (FIG. 22B), and frequency -LEE (FIG. 22C). In each FIG, LEE is plotted according to the variation series, and a schematic diagram of the plan view is provided to indicate those with circular or equilateral triangular column holes. A schematic diagram of a cross-sectional view is also provided outside the graph to distinguish them from those with other structures, which will be discussed later. In the plan view, the shape of the black area is indicated by the shape of the column hole, and the cross-sectional view shows that the active layer is removed at the location passing through the said column hole. The arrows from the plan view point to the location of the active layer occupancy ratio that results in the shape of that figure.

In particular, in FIGS. 22A and B, the arrows point to the location and data of the active layer occupancy ratio that resulted in the highest LEE for each of the circular and equilateral triangle-shaped column hole designs, and the plan view is an accurate depiction of the ratio under those conditions. The parameters a and d employed to achieve that active layer occupancy ratio are also shown as appropriate. Parameter a is a parameter (FIG. 4C) that defines the planar shape of the unit cell 10 as a rectangular area with $(3)^{1/2}/2a$ and a as vertical and horizontal sides. The parameter d is twice the radius r of the circle (i.e., the diameter) for those with circular shaped column holes, and the length of one variation of the equilateral triangle determined by d = $(3)^{1/2}r$ using r in FIG. 4C for those with equilateral triangle shaped column holes. As is clear in FIG. 22B, higher LEE is achieved at positions with larger active layer occupancy ratios in the equilateral triangle-shaped column holes than in the case of circular column holes.

Namely, the possibility of light extraction with a high LEE of 0.8 or higher in a circular column hole was confirmed in the range of 0.13-0.45, where the active layer occupancy ratio is relatively small, and the LEE is 0.982 at the center with an active layer occupancy ratio of 0.255. When the active layer occupancy ratio is small, the column hole occupancy ratio is large, and the associated operating conditions need to be considered. For example, there is a need to adjust the electronic band structure, which determines electrical performance, and the one-dimensional NEGF (non-equilibrium Green's function method) performance prediction must reflect three-dimensional effects. In addition, the small active layer occupancy ratio also means that the electronic band structure must be taken into account in the optical gain calculations. Small active layer occupancy ratios may also increase the current density. On the other hand, high LEE is performed over a relatively wide frequency range (FIG. 22C).

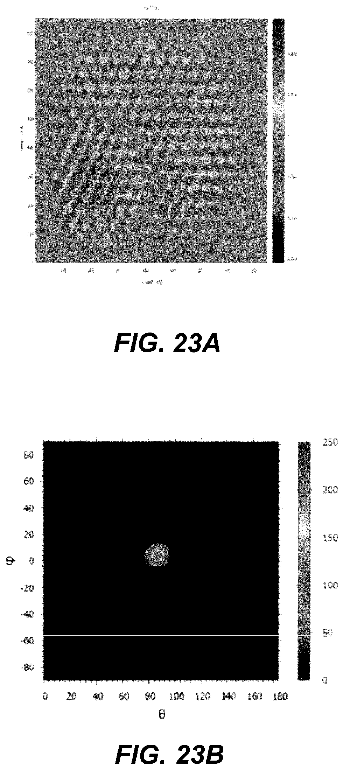

On the other hand, high light extraction with high efficiency in the equilateral triangular-shaped column holes is performed under the conditions around 0.53-0.73, where the active layer occupancy ratio is relatively large. In FIG. 22B, the T1, T2, and T3 modes are shown in order from the line with the lowest frequency, and LEEs exceeding 0.75 can be realized in any of these modes. The above-mentioned concern about the small active layer occupancy ratio need not be considered for the equilateral triangular shape, so if the design can be tailored to the desired frequency, the use of equilateral triangular column holes is very useful. FIG. 23A and FIG. 23B show, as an example, the electric field distribution (FIG. 23A) and far-field pattern (FIG. 23B) in operation at a frequency of 1.95 THz for an equilateral triangle-shaped column hole with a = 64 $\mu$m, h = 8.5 $\mu$m, and r = 34 $\mu$m (active layer occupancy ratio = 0.577). High LEE is achieved, and the radiation profile is also concentrated near the plane normal, which predicts high-quality surface emission operation.

Even in a structure that employs circular column holes, a radiation profile centered on an orientation inclined about 20° from the plane normal has been obtained for a LEE of 0.982 at a = 64 $\mu$m, h = 8.5 $\mu$m, and radius r = 29 $\mu$m (active layer occupancy ratio = 0.255), which is a high LEE (not shown in the figure).

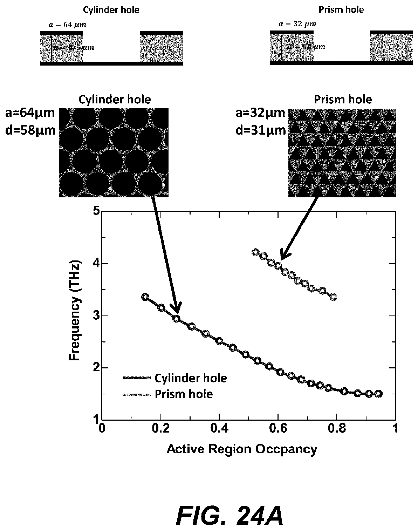

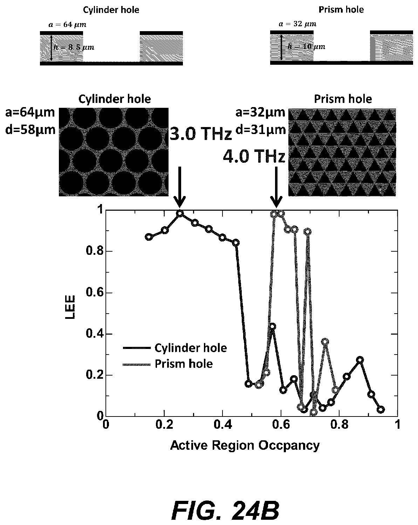

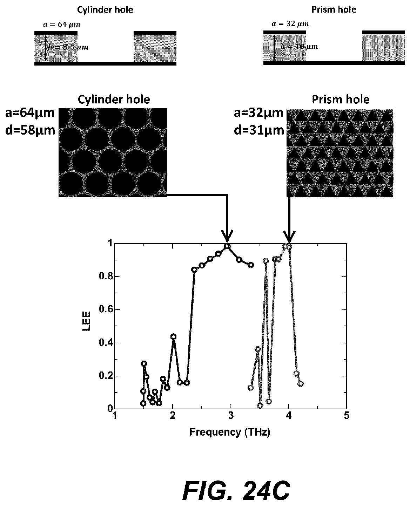

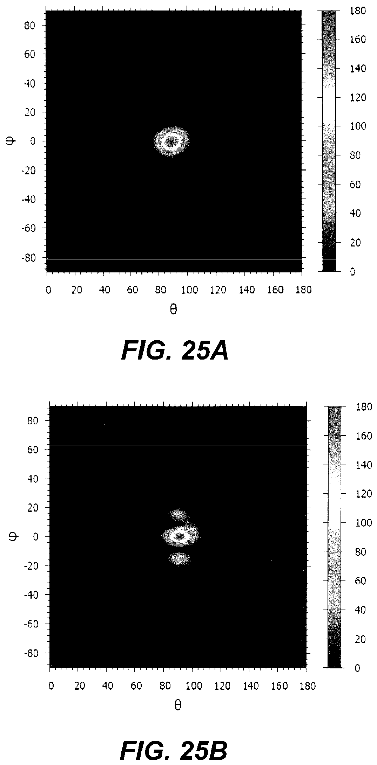

In the present embodiment, the frequency at which a good LEE or beam profile is obtained can be adjusted by changing the dimension that determines the shape (e.g., a, which gives the lattice constant of the triangular lattice). Here is an example of checking the frequency controllability when an equilateral triangular shaped column hole is employed. From FIG. 22A, it is difficult to achieve good operation in the 3-4 THz region under the conditions of a = 64 $\mu$m and h = 8.5 $\mu$m. Therefore, similar calculations were conducted for a total of six conditions with a combination of two conditions for a (32 and 40 $\mu$m) and three conditions for h (8.5, 10, and 11.5 $\mu$m), as conditions with reduced dimensions. Consequently, we found that when (a, h) is between (32 $\mu$m, 8.5 $\mu$m) and (32 $\mu$m, 10 $\mu$m), relatively good operation can be expected by adjusting the active layer occupancy ratio. In particular, when (a, h) is (32 $\mu$m, 10 $\mu$m) and the active layer occupancy ratio is in the range of 0.58-0.65, a high LEE is achieved and a good beam profile is performed under 3-4 THz conditions. FIGS. 24A-C show the active layer occupancy ratio - frequency (FIG. 24A), active layer occupancy ratio - LEE (FIG. 24B), and frequency - LEE (FIG. 24C) for equilateral triangle-shaped and circular column holes. In FIGS. 24A-C, the calculation results are provided for the case where (a, h) is (32 $\mu$m, 10 $\mu$m) for those with equilateral triangular-shaped column holes. The results for circular column holes in FIGS. 22A-C are presented as is for comparison. Schematic diagrams of cross sections and plan views are provided outside the graphs, and the definitions of the parameters therein are the same as those described above for FIGS. 22A and B. FIGS. 25A and 25B are the beam profiles when (a, h, r, active layer occupancy ratio, frequency) are (32 $\mu$m, 10 $\mu$m, 15.5 $\mu$m, 0.648, 3.77 THz) and (32 $\mu$m, 10 $\mu$m, 16.5 $\mu$m, 0.601, 3.95 THz). The respective LEEs are 0.904 and 0.981, confirming that good operation in the 3-4 THz region in the present embodiment can also be performed with the necessary design changes.

8.2 Openings for Electrodes Only

In the present embodiment, a photonic crystal with column holes through both the second electrode 102 and the semiconductor superlattice structure 110, as shown in FIG. 4B, is not necessarily required. In the present embodiment, it is also useful to employ a structure that employs, among the second electrode 102 and the semiconductor superlattice structure 110, a photonic crystal that has a pattern of openings in the second electrode 102, but the semiconductor superlattice structure 110 is a uniform structure that is not patterned (hereinafter referred to as a metal photonic crystal). We have attempted to design a specific design in which metal photonic crystals are employed by applying the selection policy described above.

As in FIG. 21 and FIG. 22, the modes of the photonic bands of the metal photonic crystal in the case of circular and equilateral triangular apertures were calculated by applying the selection policy described above under the conditions of a = 64 $\mu$m and h = 8.5 $\mu$m. The modes were selected based on the FDM, excluding modes with a Q-value (Quality Factor) of less than 1 and an error rate of more than $1 \times 10^{-4}$. As a result, no candidate conditions remained for metal photonic crystals with circular apertures. In contrast, two modes were selected as candidates for metal photonic crystals with equilateral triangles. The cross-sectional FIG indicates that the semiconductor superlattice structure is located directly under the aperture pattern of the electrode, regardless of whether or not it is directly under the aperture pattern. Note that FF is a numerical value indicating the coverage ratio of the electrode that satisfies the relationship FF + active layer occupancy ratio = 1 using the active layer occupancy ratio when column holes are employed, and is used for explanation because the semiconductor superlattice structure 110 is not patterned in the metal photonic crystal. Thus, under the conditions of a = 64 $\mu$m and h = 8.5 $\mu$m, good surface emission operation can be expected, as it shows high LEE around 1.25 THz when FF is 0.37 (active layer occupancy ratio is 0.63) and around 1.7 THz when FF is 0.47 (active layer occupancy ratio is 0.53).

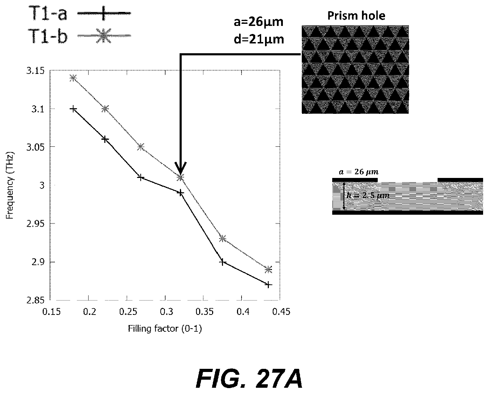

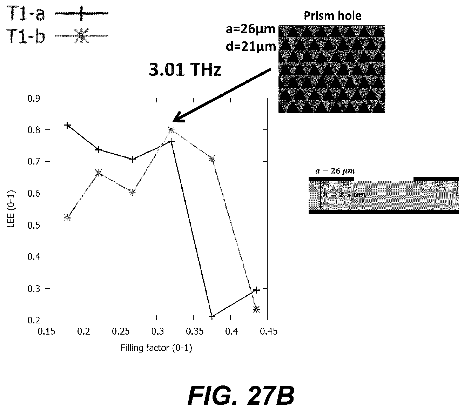

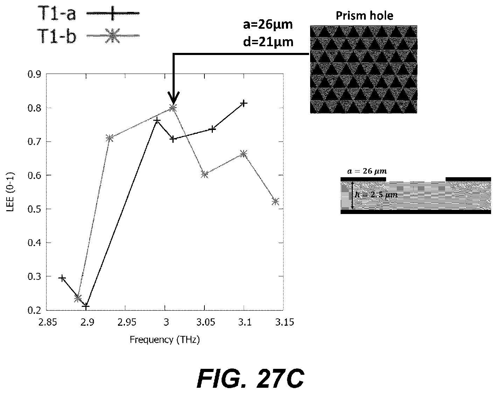

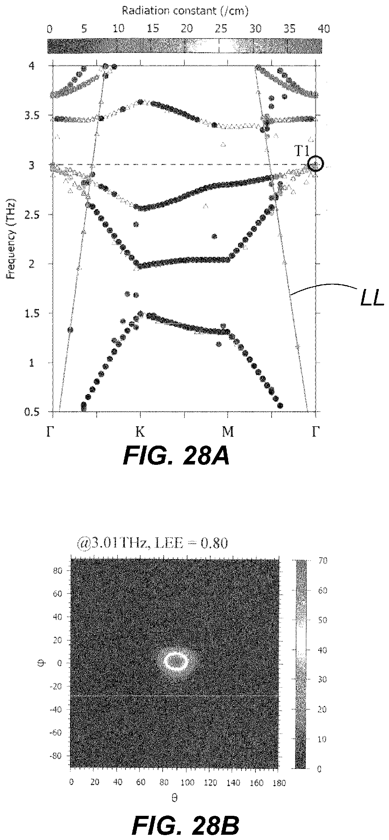

Furthermore, the possibility of favorable operation in the 3-4 THz frequency range was explored for the case where the aperture is an equilateral triangle by changing the dimensions that determine the shape. Here, a = 26 $\mu$m was investigated with h set to 2.5 $\mu$m, 5.0 $\mu$m, and 10 $\mu$m. It was confirmed that the condition with h = 2.5 $\mu$m and r = 12 $\mu$m (FF = 0.320, i.e., active layer occupancy ratio = 0.680) was favorable. FIGS. 27A-C present the calculation results under the conditions where h is 2.5 $\mu$m and r is 12 $\mu$m when equilateral triangle-shaped column holes are employed, indicating the active layer occupancy ratio - frequency (FIG. 27A), active layer occupancy ratio - LEE (FIG. 27B), and frequency -LEE (FIG. 27C). Here we show the calculation results for two modes, distinguished as T1-a and T1-b, which give different frequencies in the promising mode named T1, with cross-sectional and plan view outside the graph. In the T1-b mode, we confirmed that the LEE can be 0.8 at 3.01 THz operation under the condition that the FF is 0.320. We also confirmed that a very good beam profile is performed at 3.01 THz in this mode of operation. FIG. 28A-B shows the photonic band structure (FIG. 28A) and the far-field pattern (FIG. 28B) under these conditions. The photonic band structure shows that the band gap is at a frequency of about 3 to 3.4 THz, with a mode (T1) only near the $\Gamma$ point at about 3 THz that gives the lower band gap limit. The radiation constant of that mode satisfies 10 through 40/cm. Since this design has a mode only near the $\Gamma$ point, the radiation is expected to be centered near the normal to the two-dimensional extent that forms the metal photonic crystal, and a favorable radiation profile is predicted at a frequency of 3.01 THz (FIG. 28B). Even at 2.99 THz, a slightly lower T1-a mode near the similar $\Gamma$ point, the LEE drops to about 0.763 (FIG. 27B), but still maintains favorable operation (not shown).

8.3 Summary of Detailed Investigation

As described above, we have confirmed that in the case where a metal photonic crystal with a triangular lattice is employed for both the apertures of the second electrode 102 and the column holes of the semiconductor superlattice structure 110 or only for the apertures of the second electrode 102, we can design a successfully operable PhC- QCL element 1000.

9. Summary

In this disclosure, we have revisited the appropriate modes for surface-emitting PhC-QCLs with high EQE and low beam divergence based on photonic band engineering. Specifically, we have shown an example unit cell structure that follows the technique of FIG. 2B and FIGS. 6A, 6B. However, if we have the photonic bands illustrated in FIG. 2B, we can design a surface-emitting PhC-QCL with small beam divergence, even with arbitrary waveguide structures. In this case, the photonic crystals do not adversely affect the operation of the QCL element, and the manufacturing process can be simplified by providing electrodes that have no electrically isolated parts and that do not interfere with conduction. Therefore, the studied example structure per se has significance. Our results may open future possibilities for significant EQE improvement in PhC-QCLs.

In the above description, the embodiment of the present disclosure has been described specifically. Any description in the above is for the purpose of explaining the present disclosure, therefore the scope of the invention of this disclosure should be determined based on the recitation of the claims. In addition, other variations based on any combination of the embodiment are included in the present disclosure, which variation should also be within a scope of the claims.

Industrial Applicability

The PhC-QCL element of the present disclosure is used in any device that makes use of it

Reference Signs List

| 1000 | PhC-QCL element |
| 10 | unit cell |
| 20 | column hole |
| 90 | substrate |
| 101 | electrode (first electrode) |
| 102 | electrode (second electrode) |
| 110 | semiconductor superlattice structure |
| 112 | active region |
| LL | light line |

**Claims**

1.  A quantum cascade laser element comprising:

    a first electrode, which is a uniform film extending over a range;
    a semiconductor superlattice structure disposed on or above the first electrode and having an active region consisting of a plurality of unit structures that are stacked repeatedly; and
    a second electrode disposed on or above the semiconductor superlattice structure,
    wherein the second electrode has a photonic crystal including an array of apertures that pass through the photonic crystals in a thickness direction, the photonic crystal being formed to extend over the range, the array of apertures configured such that the second electrode has no electrically isolated portions in the range; and
    wherein the photonic band structure of the photonic crystal has a radiation mode at or near the $\Gamma$ point.

2.  The quantum cascade laser element according to claim 1,
    wherein radiation constant of the radiation mode is smaller than radiation constant of another mode with a larger horizontal wavenumber at the same frequency as the radiation mode.

3.  The quantum cascade laser element according to claim 1 or 2, wherein the radiation constant of the radiation mode is between 10/cm and 40/cm.

4.  The quantum cascade laser element according to claim 1,
    wherein the array of apertures is a triangular lattice.

5.  A quantum cascade laser element, comprising:

    a first electrode, which is a uniform film extending over a range;
    a semiconductor superlattice structure disposed on or above the first electrode and having an active region consisting of a plurality of unit structures that are stacked repeatedly; and
    a second electrode disposed on or above the semiconductor superlattice structure, the second electrode having a triangular lattice array of apertures extending over the range and having no electrically isolated portions in the range, the apertures passing through the photonic crystal in a thickness direction.

6.  The quantum cascade laser element according to claim 4 or 5,

    wherein the semiconductor superlattice structure is provided with an array of column holes of the same arrangement as in the triangular lattice, and
    wherein each column hole has the same cross-sectional shape as each opening of the second electrode and extends through the active region in the direction of stacking.

7. The quantum cascade laser element according to claim 4 or 5, wherein the shape of the aperture is an equilateral triangle.

8. The quantum cascade laser element according to claim 7, wherein an active layer occupancy ratio, which is a ratio of an area where no apertures are provided in the range, is between 0.53 and 0.73.

9. The quantum cascade laser element according to claim 1 or 5,

wherein the apertures are configured to have a combined shape of three equilateral triangles and a disc, the three equilateral triangles having identical size and orientation, and the equilateral triangles and the disc overlapping, and

wherein the combined shape is such that the three equilateral triangles are centered in 120° different directions at equal distances with respect to the center of the disk, and the sizes of the three equilateral triangles are such that at least one side of each equilateral triangle does not overlap the circumference of the disk in its entirety.

10. A quantum cascade laser element, comprising:

a first electrode, which is a uniform film extending over a range;

a semiconductor superlattice structure disposed on or above the first electrode and having an active region consisting of a plurality of unit structures that are stacked repeatedly; and

a second electrode disposed on or above the semiconductor superlattice structure,

wherein, in the second electrode is formed a photonic crystal including an array of apertures of equilateral triangles, the aperture passing through the photonic crystals in a thickness direction, the photonic crystal being formed to extend over the range, and

wherein the second electrode has no electrically isolated portions in the range.

11. The quantum cascade laser element according to claim 10,

wherein the photonic crystal includes an array of column holes of the same arrangement as the triangular lattice provided in the semiconductor superlattice structure,

wherein each column hole has the same cross-sectional shape as each aperture of the second electrode and extends through the active region in the direction of stacking.

12. The quantum cascade laser element according to any one of claims 5, 10, and 11, wherein the photonic crystal has a photonic band structure with radiation modes only at or near the $\Gamma$ point at a frequency of electromagnetic waves at which the active region can make an induced emission during operation.

13. The quantum cascade laser element according to claim 12, wherein the radiation mode of the photonic band provides either the lower or the upper limit of the band gap at or near the $\Gamma$ point.

14. The quantum cascade laser element according to any one of claims 1, 5, and 10, wherein the active region emits an electromagnetic wave in the THz region.

15. The quantum cascade laser element according to claim 14, wherein the frequency is any value less than or equal to 18.7 THz.

16. The quantum cascade laser element according to claim 14, wherein the first electrode and the second electrode comprise a metallic material.

17. The quantum cascade laser element according to claim 14, wherein the second electrode is a radiating surface.

18. An apparatus, comprising the quantum cascade laser element according to any one of claims 1, 5, and 10.

**FIG. 1**

**FIG. 2**

**FIG. 3**

**FIG. 4A**

**FIG. 4B**

**FIG. 4C**

Plane sensor 1

**FIG. 5A**

**FIG. 5B**

FIG. 6A

FIG. 6B

*FIG. 7*

FIG. 8A

FIG. 8B

FIG. 9A

FIG. 9B

FIG. 9C

|Ex| (V/m)

FIG. 10A

|Ey| (V/m)

FIG. 10B

|Ez| (V/m)

FIG. 10C

|Ex| (V/m)

FIG. 10D

|Ey| (V/m)

FIG. 10E

|Ez| (V/m)

FIG. 10F

**FIG. 11**

**FIG. 12A**

**FIG. 12B**

**FIG. 13**

**FIG. 14A**

**FIG. 14B**

**FIG. 14C**

FIG. 15

FIG. 16

**FIG. 17A**          **FIG. 17B**          **FIG. 17C**

Point4: (a. b+r)

Point1: $\left(a - \frac{\sqrt{3}}{4}r, b + 0.25r\right)$

Point3: $\left(a + \frac{\sqrt{3}}{4}r, b + 0.25r\right)$

r1

(a, b)

Point5: $\left(a - \frac{\sqrt{3}}{2}r, b - 0.5r\right)$

Point6: $\left(a + \frac{\sqrt{3}}{2}r, b - 0.5r\right)$

$\sqrt{3}r$

Point2: $(a, b - 0.5r)$

## FIG. 18

**FIG. 19**

**FIG. 20A**

Photonic band

**FIG. 20B**

Frequency of far-field = 2.73 THz,
Power ratio = 7.21

**FIG. 21A**

**FIG. 21B**

**Cylinder hole**

a=64μm
d=58μm

**Prism hole**

a=64μm
d=62μm

Uniform Triangular Prism 1
Uniform Triangular Prism 2
Uniform Triangular Prism 3
Cylinder

Cylinder hole        Prism hole

$a = 64\ \mu m$

$h = 8.5\ \mu m$

## FIG. 22A

FIG. 22B

**FIG. 22C**

**FIG. 23A**

**FIG. 23B**

**FIG. 24A**

FIG. 24B

FIG. 24C

FIG. 25A

FIG. 25B

**FIG. 26A**

**Prism hole**

a=64μm
d=62μm

**1.25 THz**

**1.7 THz**

Equilateral triangle 1 —+—
Equilateral triangle 2 —*—

*FIG. 26B*

FIG. 26C

**FIG. 27A**

**FIG. 27B**

FIG. 27C

**FIG. 28A**

**FIG. 28B**

## INTERNATIONAL SEARCH REPORT

| International application No. |
| --- |
| **PCT/JP2022/039093** |

**A. CLASSIFICATION OF SUBJECT MATTER**

*H01S 5/11*(2021.01)i; *H01S 5/34*(2006.01)i
FI: H01S5/11; H01S5/34

According to International Patent Classification (IPC) or to both national classification and IPC

**B. FIELDS SEARCHED**

Minimum documentation searched (classification system followed by classification symbols)

H01S5/00-5/50

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

JSTPlus/JST7580 (JDreamIII)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2019-47023 A (TOSHIBA CORP) 22 March 2019 (2019-03-22) paragraphs [0010]-[0062], fig. 1-15 | 5-8, 10-11, 14-18 |
| Y | | 1-4, 12-13 |
| A | | 9 |
| Y | JP 2018-93022 A (TOSHIBA CORP) 14 June 2018 (2018-06-14) paragraphs [0036]-[0037], fig. 7 | 1-4, 12-13 |
| Y | US 2005/0063438 A1 (CAPASSO, Federico) 24 March 2005 (2005-03-24) paragraphs [0022], [0055], fig. 1A | 1-4, 12-13 |
| Y | YOSHIDA, Masahiro et al. Photonic-crystal lasers with high-quality narrow-divergence symmetric beams and their application to LiDAR. Journal of Physics: Photonics. 18 March 2021, vol. 3, article number 022006, pp. 1-15 in particular, p. 3, line 16 to p. 7, line 13, fig. 2, 5 | 1-4, 12-13 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **06 December 2022** | **20 December 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

International application No.

**PCT/JP2022/039093**

C.      DOCUMENTS CONSIDERED TO BE RELEVANT

| Category* | Citation of document, with indication, where appropriate, of the relevant passages | Relevant to claim No. |
|---|---|---|
| Y | PENG, Chao et al. Three-dimensional coupled-wave theory analysis of a centered-rectangular lattice photonic crystal laser with a transverse-electric-like mode. PHYSICAL REVIEW B. 2012, vol. 86, pp. 035108-1 to 035108-11 <br> in particular, p. 1, right column, lines 1-3, fig. 3-4 | 1-4, 12-13 |

Form PCT/ISA/210 (second sheet) (January 2015)

## INTERNATIONAL SEARCH REPORT
### Information on patent family members

| International application No. |
| --- |
| **PCT/JP2022/039093** |

| Patent document cited in search report | | | Publication date (day/month/year) | Patent family member(s) | Publication date (day/month/year) |
| --- | --- | --- | --- | --- | --- |
| JP | 2019-47023 | A | 22 March 2019 | US 2019/0074663 A1 paragraphs [0023]-[0085], fig. 1-15 <br> EP 3457506 A1 <br> CN 109428262 A | |
| JP | 2018-93022 | A | 14 June 2018 | (Family: none) | |
| US | 2005/0063438 | A1 | 24 March 2005 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017168594 A

**Non-patent literature cited in the description**

- **R. COLOMBELLI ; K. SRINIVASAN ; M. TROCCOLI ; O. PAINTER ; C. F. GMACHL ; D. M. TENNANT ; A. M. SERGENT ; D. L. SIVCO ; A. Y. CHO ; F. CAPASSO.** Quantum cascade surface-emitting photonic crystal laser. *Science,* 2003, vol. 302 (5649), 1374-1377, https://doi.org/10.1126/science.1090561
- **GUOZHEN LIANG ; HOUKUN LIANG ; YING ZHANG ; LIANHE LI ; A. GILES DAVIES ; EDMUND LINFIELD ; SIU FUNG YU ; HUI CHUN LIU ; QI JIE WANG.** Low divergence single-mode surface-emitting concentric-circular-grating terahertz quantum cascade lasers. *Optics Express,* 2013, vol. 21 (26), 31872-31882, https://doi.org/10.1364/OE.21.031872
- **Y. CHASSAGNEUX ; R. COLOMBELLI ; W. MAINEULT ; S. BARBIERI ; H. E. BEERE ; D. A. RITCHIE ; S. P. KHANNA ; E. H. LINFIELD ; A. G. DAVIES.** Electrically pumped photonic-crystal terahertz lasers controlled by boundary conditions. *Nature,* 2009, vol. 457, 174-178, https://doi.org/10.1038/nature07636